# EUROPEAN PATENT SPECIFICATION

(11) **EP 3 352 185 B1**
(45) Date of publication and mention of the grant of the patent: **27.10.2021**
(21) Application number: 16846281.0
(22) Date of filing: 02.09.2016
(51) Int. Cl.: H01G 9/20, C07F 15/00, C09B 57/10, C09B 23/14

(54) **PHOTOELECTRIC CONVERSION ELEMENT, DYE-SENSITIZED SOLAR CELL, DYE COMPOSITION, AND OXIDE SEMICONDUCTOR ELECTRODE**
FOTOELEKTRISCHES UMWANDLUNGSELEMENT, FARBSTOFFSENSIBILISIERTE SOLARZELLE, FARBSTOFFZUSAMMENSETZUNG UND OXIDHALBLEITERELEKTRODE
ÉLÉMENT DE CONVERSION PHOTOÉLECTRIQUE, CELLULE SOLAIRE À COLORANT, COMPOSITION DE COLORANT, ET ÉLECTRODE D'OXYDE SEMI-CONDUCTEUR

(30) Priority: 17.09.2015 JP 2015184069; 18.12.2015 JP 2015247573; 26.04.2016 JP 2016087843
(43) Date of publication of application: 25.07.2018
(73) Proprietor: FUJIFILM Corporation, Tokyo 106-8620 (JP)
(72) Inventor: WATANABE, Kousuke, Ashigarakami-gun Kanagawa 258-8577 (JP); TANI, Yukio, Ashigarakami-gun Kanagawa 258-8577 (JP); SHIROKANE, Kenji, Ashigarakami-gun Kanagawa 258-8577 (JP); YOSHIOKA, Tomoaki, Ashigarakami-gun Kanagawa 258-8577 (JP); SASAKI, Kouitsu, Ashigarakami-gun Kanagawa 258-8577 (JP)
(74) Representative: Hoffmann Eitle
(86) International application number: PCT/JP2016/075816
(87) International publication number: WO 2017/047410

(56) References cited:
- EP-A1- 2 112 671
- CN-A- 103 665 047
- JP-A- 2011 228 276
- JP-A- 2012 188 401
- JP-A- 2013 171 641
- JP-B2- 5 620 469
- US-A1- 2007 017 569
- US-A1- 2007 017 569
- KARTHIKEYAN ET AL: "Highly efficient solid-state dye-sensitized TiO"2 solar cells via control of retardation of recombination using novel donor-antenna dyes", SOLAR ENERGY MATERIALS AND SOLAR CE, ELSEVIER SCIENCE PUBLISHERS, AMSTERDAM, NL, vol. 91, no. 5, 26 January 2007 (2007-01-26), pages 432-439, XP005862277, ISSN: 0927-0248, DOI: 10.1016/J.SOLMAT.2006.10.006
- JUN-HO YUM ET AL: "High efficient donor-acceptor ruthenium complex for dye-sensitized solar cell applications", ENERGY & ENVIRONMENTAL SCIENCE, vol. 2, no. 1, 27 October 2008 (2008-10-27), pages 100-102, XP55429641, Cambridge ISSN: 1754-5692, DOI: 10.1039/B814863P
- MIHALIK M ET AL: "Electrical transport and magnetism in CeFe"2Si"2 single crystal", PHYSICA B: CONDENSED MATTER, ELSEVIER, AMSTERDAM, NL, vol. 359-361, 30 April 2005 (2005-04-30), pages 163-165, XP027836292, ISSN: 0921-4526 [retrieved on 2005-04-30]

## Description

### BACKGROUND OF THE INVENTION

### 1. Field of the Invention

The present invention relates to a photoelectric conversion element, a dye-sensitized solar cell, a dye composition, and an oxide semiconductor electrode.

### 2. Description of the Background Art

Photoelectric conversion elements are used in various photosensors, copying machines, photo electrochemical cells such as solar cells, and the like. These photoelectric conversion elements have adopted various systems to be put into use, such as systems utilizing metals, systems utilizing semiconductors, systems utilizing organic pigments or dyes, or combinations of these elements. In particular, solar cells utilizing inexhaustible solar energy do not necessitate fuels, and full-fledged practicalization of solar cells as an inexhaustible clean energy is being highly expected. Above all, research and development of silicon-based solar cells have long been in progress, and many countries also support policy-wise considerations, and thus dissemination of silicon-based solar cells is still in progress. However, silicon is an inorganic material, and thus, naturally has limitations in terms of improvement of throughput, cost, and the like.

Thus, research is being vigorously carried out on photo electrochemical cells (also referred to as dye-sensitized solar cells) using metal complex dyes. In particular, what have built momentum toward such research was the research results from Graetzel et al. of École Polytechnique Fédérale de Lausanne in Switzerland. They employed a structure in which a dye formed from a ruthenium complex was fixed on the surface of a porous titanium oxide film, and realized photoelectric conversion efficiency which was comparable to that of amorphous silicon. Thus, dye-sensitized solar cells that can be produced even without use of expensive vacuum devices have instantly attracted the attention of researchers all over the world.

Hitherto, dyes called N3, N719, and N749 (also referred to as Black Dye), Z907, and J2 have generally been developed as metal complex dyes for use in dye-sensitized solar cells.

In addition to these metal complex dyes, various metal complex dyes have been studied.

For example, JP2001-291534A specifically describes a dye (D-3) having a bipyridine ligand including a diphenylaminostyryl skeleton, and two isothiocyanate groups (-NCS) as an example of the metal complex dye. Further, JP2013-072079A specifically describes a dye (D-1-7a) having a bipyridine ligand including a di(tertiary butylphenyl)aminostyryl skeleton, and two isothiocyanate groups, and a dye (D-1-9a) having a bipyridine ligand including a styryl skeleton having a 3,6-di-tertiary butylcarbazolyl group, and two isothiocyanate groups as an example of the metal complex dye. The metal complex dyes described in JP2001-291534A and JP2013-072079A are described to have a high molar light absorption coefficient, and thus exhibit high conversion efficiency.

Furthermore, JP2008-021496A specifically describes a dye (40) having a bipyridine ligand including a di(methylphenyl)aminostyryl skeleton, and two isothiocyanate groups, and the like.

Solar Energy Materials & Solar Cells 91 (2007) 432-439 describes the preparation of heteroleptic tris(bipyridyl)Ru(II) and bis(bipyridyl)(NCS)2Ru(II) complexes, as well as solid-state dye-sensitized solar cells comprising such complexes.

### SUMMARY OF THE INVENTION

The applications of photoelectric conversion elements and dye-sensitized solar cells have been extended to those in a low-illumination environment in which a luminance is lower than that of solar light in a clear weather, for example, in low-illumination solar light in a cloudy weather, a rainy weather, or the like, or in an indoor or low-illumination environment using an illumination device such as a fluorescent light lamp. Accordingly, it is desired to improve and stabilize cell performance in recent photoelectric conversion elements and dye-sensitized solar cells even in such a low-illumination environment. In the present invention, the low-luminance environment is not particularly limited, but refers to an environment with a luminance of 10,000 lux or less.

However, in the photoelectric conversion elements and the dye-sensitized solar cells, with regard to metal complex dyes in the related art, a deviation of photoelectric conversion efficiency among the elements at an initial time (after the production) is easily generated, and particularly in a low-illumination environment, the deviation width among the elements is large in the photoelectric conversion efficiency at an initial time increases.

It is an object of the present invention to provide a photoelectric conversion element and a dye-sensitized solar cell, each of has a reduced deviation of photoelectric conversion efficiency among photoelectric conversion elements, as well as a dye composition and an oxide semiconductor electrode, each of which is used in the photoelectric conversion element and the dye-sensitized solar cell.

The present inventors have conducted various studies on a metal complex dye used for a photoelectric conversion element and a dye-sensitized solar cell, and thus, have found that it is possible to reduce the deviation of photoelectric conversion efficiency even in a low-illumination environment with a photoelectric conversion element, by using a metal complex dye having a bipyridine ligand having a p-diphenylaminostyryl group or the like at the 4-position of each pyridine ring, a bipyridine ligand having a carboxyl group in each pyridine ring, and two isothiocyanate groups, together with a metal complex dye in which at least one isothiocyanate group is changed to a specific monodentate ligand, as the metal complex dye of the photoelectric conversion element. Based on these findings, the present invention has been completed by further repeating the studies.

That is, the objects of the present invention have been achieved by the following means.
<1> A photoelectric conversion element comprising:
   an electrically conductive support;
   a photoconductor layer including an electrolyte;
   a charge transfer layer including an electrolyte; and
   a counter electrode,
   in which the photoconductor layer has semiconductor fine particles carrying a metal complex dye represented by Formula (1), and at least one metal complex dye selected from the group consisting of a metal complex dye represented by Formula (2) and a metal complex dye represented by Formula (3).

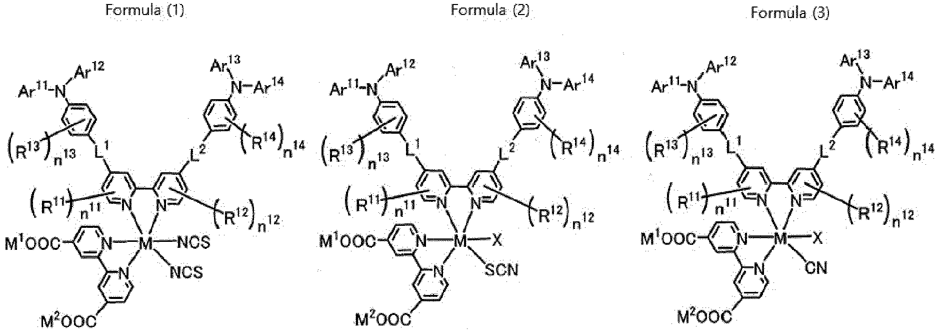

   In the formulae, M represents a metal ion.
   Ar¹¹ to Ar¹⁴ each independently represent an aryl group or a heteroaryl group, each having a substituent selected form a substituent group T,
      <Substituent group T>:
      an alkyl group, an alkenyl group, an alkynyl group, a cycloalkyl group, an cycloalkenyl group, an aryl group, a heterocyclic group, an alkoxy group, an alkenyloxy group, an alkynyloxy group, a cycloalkyloxy group, an aryloxy group, a heterocyclic oxy group, an alkoxycarbonyl group, a cycloalkoxycarbonyl group, an aryloxycarbonyl group, an amino group, a sulfamoyl group, an acyl group, an acyloxy group, a carbamoyl group, an acylamino group, a sulfonamido group, an alkylthio group, a cycloalkylthio group, an arylthio group, an alkyl-, cycloalkyl-, or aryl-sulfonyl group, a silyl group, a silyloxy group, a hydroxyl group, a cyano group, a nitro group, and a halogen atom.
   L¹ and L² each independently represent an ethenylene group or an ethynylene group.
   R¹¹ to R¹⁴ each independently represent an alkyl group, an alkoxy group, an aryl group, an alkylthio group, a heteroaryl group, an amino group, or a halogen atom. n¹¹ and n¹² each independently represent an integer of 0 to 3, and n¹³ and n¹⁴ each independently represent an integer of 0 to 4.
   X's each independently represent an isothiocyanate group or a thiocyanate group.
   M¹ and M² each independently represent any one of a proton, a metal cation, and a non-metal cation.
<2> The photoelectric conversion element as described in <1>,
   in which at least one of the metal complex dyes includes the metal complex dye represented by Formula (2).
<3> The photoelectric conversion element as described in <1> or <2>,
   in which Ar¹¹ to Ar¹⁴ are each independently represented by any one of Formulae (2-1) to (2-5). 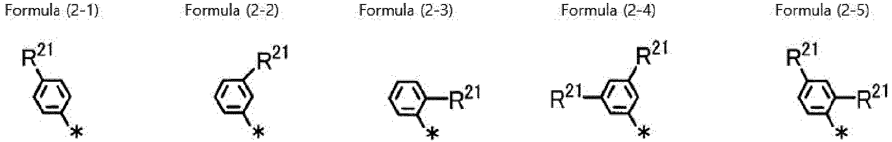
   In the formula, R²¹ represents a hydrogen atom, an alkyl group, an aryl group, a heteroaryl group, an alkoxy group, or a halogen atom. ^{∗} represents a bonding moiety to a nitrogen atom.
<4> The photoelectric conversion element as described in any one of <1> to <3>,
   in which the semiconductor fine particles carries a metal complex dye including at least the metal complex dye represented by Formula (1) and the metal complex dye represented by Formula (2), in which the content ratio of the metal complex dye represented by Formula (1) to the metal complex dye represented by Formula (2) is 1.0/0.01 to 2 in terms of the molar ratio of the metal complex dye represented by Formula (1)/the metal complex dye represented by Formula (2).
<5> The photoelectric conversion element as described in any one of <1> to <4>,
   in which a metal oxide coating film is included on the surface of at least one of the electrically conductive support or the semiconductor fine particles.
<6> A dye-sensitized solar cell comprising the photoelectric conversion element as described in any one of <1> to <5>.
<7> A dye composition comprising a metal complex dye represented by Formula (1), and at least one metal complex dye selected from the group consisting of a metal complex dye represented by Formula (2) and a metal complex dye represented by Formula (3). 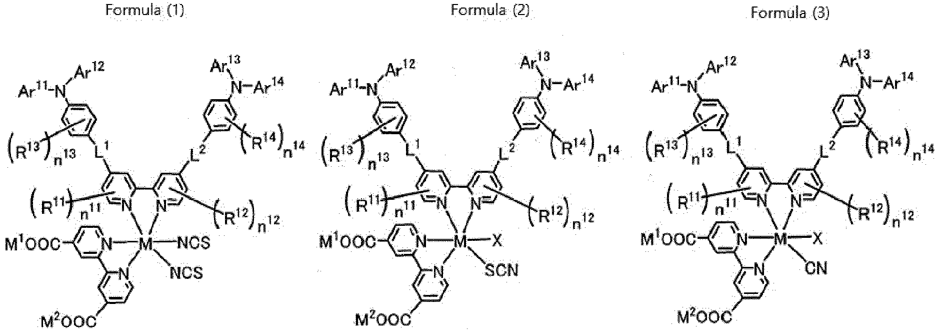
   In the formula, M represents a metal ion.
   Ar¹¹ to Ar¹⁴ each independently represent an aryl group or a heteroaryl group, each having a substituent selected form a substituent group T,
      <Substituent group T>:
      an alkyl group, an alkenyl group, an alkynyl group, a cycloalkyl group, an cycloalkenyl group, an aryl group, a heterocyclic group, an alkoxy group, an alkenyloxy group, an alkynyloxy group, a cycloalkyloxy group, an aryloxy group, a heterocyclic oxy group, an alkoxycarbonyl group, a cycloalkoxycarbonyl group, an aryloxycarbonyl group, an amino group, a sulfamoyl group, an acyl group, an acyloxy group, a carbamoyl group, an acylamino group, a sulfonamido group, an alkylthio group, a cycloalkylthio group, an arylthio group, an alkyl-, cycloalkyl-, or aryl-sulfonyl group, a silyl group, a silyloxy group, a hydroxyl group, a cyano group, a nitro group, and a halogen atom.
   L¹ and L² each independently represent an ethenylene group or an ethynylene group.
   R¹¹ to R¹⁴ each independently represent an alkyl group, an alkoxy group, an aryl group, an alkylthio group, a heteroaryl group, an amino group, or a halogen atom. n¹¹ and n¹² each independently represent an integer of 0 to 3, and n¹³ and n¹⁴ each independently represent an integer of 0 to 4.
   X's each independently represent an isothiocyanate group or a thiocyanate group.
   M¹ and M² each independently represent any one of a proton, a metal cation, and a non-metal cation.
<8> The dye composition as described in <7>,
   in which 0.000001 to 1.5 moles in total of the metal cation and the non-metal cation in the total molar amount of M¹ and M² contained in the metal complex dye are contained.
<9> The dye composition as described in <7> or <8>, comprising at least:
   the metal complex dye represented by Formula (1); and
   the metal complex dye represented by Formula (2),
   in which the content ratio of the metal complex dye represented by Formula (1) to the metal complex dye represented by Formula (2) in such the case is 1.0/0.01 to 2 in terms of the molar ratio of the metal complex dye represented by Formula (1)/the metal complex dye represented by Formula (2).
<10> The dye composition as described in any one of <7> to <9>, comprising a solvent.
<11> An oxide semiconductor electrode comprising the dye composition as described in any one of <7> to <10>.

In the present specification, in a case where a double bond exists in an E configuration or a Z configuration in the molecule, it may be either one of the two configurations or a mixture thereof unless otherwise specified.

In a case where there are a plurality of substituents, linking groups, ligands, or the like (hereinafter referred to as substituents or the like) represented by specific symbols, or in a case where a plurality of substituents and the like are defined at the same time, the respective substituents or the like may be the same as or different from each another unless otherwise specified. This shall also apply to the definition of the number of substituents or the like. Further, in a case where a plurality of substituents and the like are close to each other (in particular, adjacent to each other), they may be linked to each other to form a ring, unless otherwise specified. In addition, the ring, for example, an alicycle, an aromatic ring, or a heterocycle may further be fused to form a fused ring, unless otherwise specified.

In the present specification, reference to a compound (including a complex and a dye) is used to encompass, in addition to the compound itself, salts and ions of the compound. Further, within a scope in which desired effects are exhibited, the reference is used to encompass modifications of some of the structure. In addition, a compound for which substitution or non-substitution is not explicitly described is meant to indicate that the compound may have an arbitrary substituent within a scope in which desired effects are exhibited. This shall also apply to substituents, linking groups, and ligands.

In addition, in the present specification, a numerical value range represented by "(a value) to (a value)" means a range including the numerical values represented before and after "to" as a lower limit value and an upper limit value, respectively.

According to the present invention, it is possible to provide a photoelectric conversion element and a dye-sensitized solar cell, each of which has a reduced deviation of photoelectric conversion efficiency among the photoelectric conversion elements, as well as a dye composition and an oxide semiconductor electrode, each of which is used in the photoelectric conversion element and the dye-sensitized solar cell.

The above or other characteristics and advantages of the present invention will further be clarified from the following description with reference to drawings appropriately attached hereto.

### BRIEF DESCRIPTION OF THE DRAWING

Fig. 1 is a cross-sectional view schematically showing a photoelectric conversion element in the first aspect of the present invention, including an enlarged view of the circled portion in a layer thereof, in a system in which the photoelectric conversion element is applied in cell uses.
Fig. 2 is a cross-sectional view schematically showing a dye-sensitized solar cell including a photoelectric conversion element in the second aspect of the present invention.

### DESCRIPTION OF THE PREFERRED EMBODIMENTS

### [Photoelectric Conversion Element and Dye-Sensitized Solar Cell]

The photoelectric conversion element of the present invention has an electrically conductive support, a photoconductor layer including an electrolyte, a charge transfer layer including an electrolyte, and a counter electrode (opposite electrode). The photoconductor layer, the charge transfer layer, and the counter electrode are provided in this order on the electrically conductive support.

In the photoelectric conversion element of the present invention, the semiconductor fine particles forming the photoconductor layer carry a metal complex dye represented by Formula (1) which will be described later, and at least one metal complex dye selected from the group consisting of metal complex dyes represented by Formulae (2) and (3) which will be described later (which will be described later a dye composition), as a sensitizing dye. Here, the aspect in which the metal complex dye is carried on the surface of the semiconductor fine particles encompasses an aspect in which the metal complex dye is deposited on the surface of the semiconductor fine particles, an aspect in which the metal complex dye is adsorbed onto the surface of the semiconductor fine particles, and a mixture of these aspects. The adsorption encompasses chemical adsorption and physical adsorption, with the chemical adsorption being preferable.

The semiconductor fine particles may carry other metal complex dyes, together with the metal complex dyes represented by Formulae (1) to (3) which will be described later.

Moreover, the photoconductor layer includes an electrolyte. The electrolyte included in the photoconductor layer may be the same as or different from the electrolyte included in the charge transfer layer, but they are preferably the same as each other.

The photoelectric conversion element of the present invention is not particularly limited in terms of configurations other than the configuration defined in the present invention, and may adopt and use known configurations regarding photoelectric conversion elements. The respective layers constituting the photoelectric conversion element of the present invention are designed depending on purposes, and may be formed into, for example, a single layer or multiple layers. Further, layers other than the layers may be included, as necessary.

The dye-sensitized solar cell of the present invention is formed, using the photoelectric conversion element of the present invention.

Hereinafter, preferred embodiments of the photoelectric conversion element and the dye-sensitized solar cell of the present invention will be described.

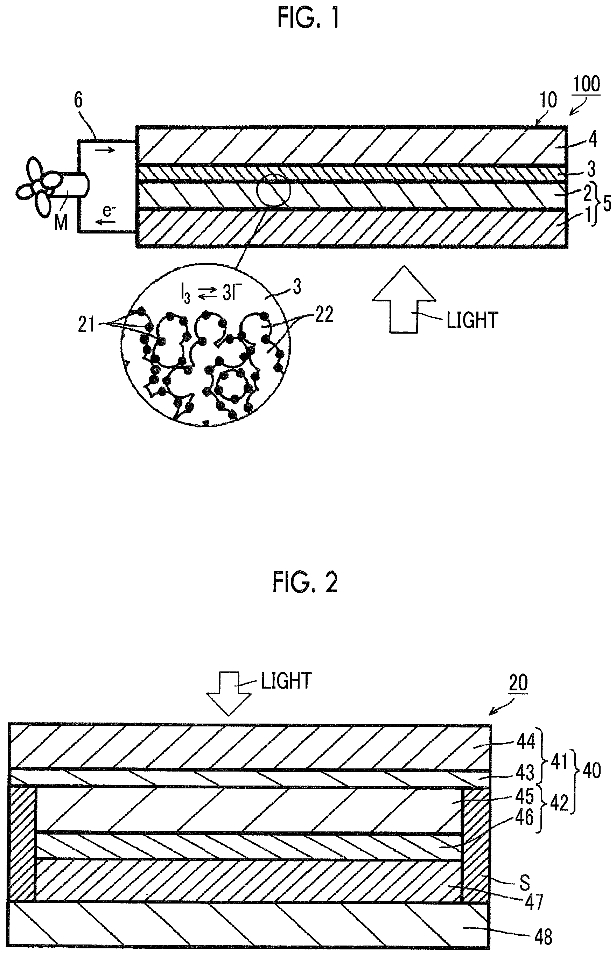

A system 100 shown in Fig. 1 is a system in which a photoelectric conversion element 10 in the first aspect of the present invention is applied in cell uses where an operating means M (for example, an electric motor) in an external circuit 6 is forced to work.

The photoelectric conversion element 10 includes semiconductor fine particles 22 sensitized by carrying an electrically conductive support 1 and a dye (metal complex dye) 21, a photoconductor layer 2 including an electrolyte between the semiconductor fine particles 22, a charge transfer layer 3 that is a hole transport layer, and a counter electrode 4.

In the photoelectric conversion element 10, the photoconductor layer 2 has the metal complex dye represented by Formula (1), and at least one metal complex dye of the metal complex dye represented by Formula (2) and the metal complex dye represented by Formula (3) adsorbed on the semiconductor fine particles 22, which is also referred to as an oxide semiconductor electrode. Further, the light-receiving electrode 5 has the electrically conductive support 1 and the photoconductor layer 2, and functions as a functional electrode.

In the system 100 in which the photoelectric conversion element 10 is applied, light incident to the photoconductor layer 2 excites the metal complex dye 21. The excited metal complex dye 21 has electrons having high energy, and these electrons are transferred from the metal complex dye 21 to a conduction band of the semiconductor fine particles 22, and further reach the electrically conductive support 1 by diffusion. At this time, the metal complex dye 21 is in an oxidized form (cation). While the electrons reaching the electrically conductive support 1 work in an external circuit 6, they reach the oxidized form of the metal complex dye 21 through the counter electrode 4 and the charge transfer layer 3, and the oxidized form is reduced. By repeating a cycle of the excitation of the metal complex dye and the electron movement, the system 100 functions as a solar cell.

A dye-sensitized solar cell 20 shown in Fig. 2 is constituted with the photoelectric conversion element in the second aspect of the present invention.

The photoelectric conversion element which serves as the dye-sensitized solar cell 20 is different from the photoelectric conversion element shown in Fig. 1 in terms of the configurations of the electrically conductive support 41 and the photoconductor layer 42, and incorporation of a spacer S, but except for these points, has the same configuration as the photoelectric conversion element 10 shown in Fig. 1. That is, the electrically conductive support 41 has a bilayered structure including a substrate 44 and a transparent electrically-conductive film 43 which is formed on the surface of the substrate 44. Further, the photoconductor layer 42 has a bilayered structure including a semiconductor layer 45 and a light-scattering layer 46 which is formed adjacent to the semiconductor layer 45. The photoconductor layer 42 has at least the metal complex dye represented by Formula (1), and at least one metal complex dye of the metal complex dye represented by Formula (2) and the metal complex dye represented by Formula (3), adsorbed on semiconductor fine particles which form the photoconductor layer 42, which is also referred to as an oxide semiconductor electrode. A spacer S is provided between the electrically conductive support 41 and the counter electrode 48. In the dye-sensitized solar cell 20, 40 is a light-receiving electrode and 47 is a charge transfer layer.

In a similar manner to the system 100 in which the photoelectric conversion element 10 is applied, the dye-sensitized solar cell 20 functions as a solar cell by light incident on the photo conductor layer 42.

The photoelectric conversion element and the dye-sensitized solar cell of the present invention exhibit excellent photoelectric conversion efficiency even in a low-illumination environment, as described above. Accordingly, they can also be suitably used even in a low-illumination environment.

A dye-sensitized solar cell using the photoelectric conversion element of the present invention is also referred to as a dye-sensitized photoelectrochemical cell.

The photoelectric conversion element and the dye-sensitized solar cell of the present invention are not limited to the above preferred aspects, and the configuration of each of the aspects can be combined as appropriate within a range not departing from the scope of the present invention.

In the present invention, the materials and the respective members for use in the photoelectric conversion element and the dye-sensitized solar cell can be prepared by ordinary methods. Reference can be made to, for example, US4927721A, US4684537A, US5084365A, US5350644A, US5463057A, US5525440A, JP1985-249790A (JP-H07-249790A), JP2001-185244A, JP2001-210390A, JP2003-217688A, JP2004-220974A, and JP2008-135197A.

### <Metal complex dyes Represented by Formulae (1) to (3)>

In the present invention, a metal complex dye represented by Formula (1) (hereinafter also referred to as a metal complex dye (1) in some cases), and at least one metal complex dye selected from the group consisting of a metal complex dye represented by Formula (2) and a metal complex dye represented by Formula (3) are used in combination as the metal complex dye. In the present invention, as the metal complex dye to be used in combination with the metal complex dye (1), the metal complex dye represented by Formula (2) (hereinafter also referred to as a metal complex dye (2)) is preferable. The metal complex dye represented by Formula (3) (hereinafter also referred to as a metal complex dye (3) in some cases) may be used in combination with either the metal complex dye (1), or the metal complex dye (1) and the metal complex dye (2).

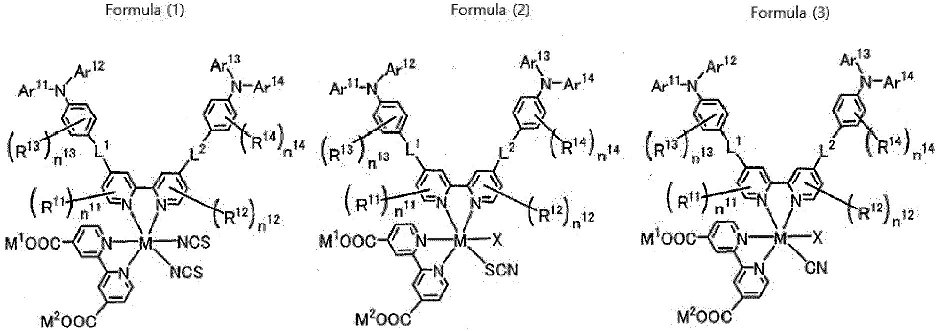

By using the metal complex dye (1), and at least one metal complex dye selected from the group consisting of the metal complex dye (2) and the metal complex dye (3) in combination, the deviation of the photoelectric conversion efficiency among the photoelectric conversion element among the photoelectric conversion elements is reduced.

Details of the reasons therefor are still not clear, but are presumed to be as follows. In a case where the metal complex dye (1), and at least one metal complex dye selected from the group consisting of the metal complex dye (2) and the metal complex dye (3) are used in combination, association among the metal complex dyes is less likely to occur, as compared with a case where the metal complex dye (1) is used singly. As a result, the deviation of adsorption of the respective metal complex dyes onto the surface of the semiconductor fine particles is reduced, and thus, the surface of the semiconductor fine particles can be efficiently coated (which results in a state of being uniformly coated with the metal complex dye). Accordingly, it is thought that the deviation of photoelectric conversion efficiency at an initial time among the photoelectric conversion elements can be reduced not only with irradiation of solar light in the clear weather (also referred to a high-illumination environment) but also under low illumination.

In the present invention, an improvement in the photoelectric conversion efficiency itself can further be expected, in addition to the reduction in the deviation of the photoelectric conversion efficiency. As described above, by coating the surface of the semiconductor fine particles with the metal complex dye efficiently, a leakage current which can be generated between the electrolyte and the semiconductor fine particles (photoconductor layer) can be suppressed. As a result, the open-circuit voltage of the photoelectric conversion element is improved. Accordingly, it is thought that the photoelectric conversion element or the solar cell of the present invention has a reduced deviation of the photoelectric conversion efficiency, and thus, the photoelectric conversion efficiency itself increases.

In the present invention, in a case where the metal complex dyes (1) to (3) exist as isomers such as an optical isomer, a geometric isomer, a bond isomer, and an ionized isomer, they may be either any of these isomers or a mixture of these isomers.

In Formulae (1) to (3), M represents a metal ion, and examples thereof include ions of elements belonging to Groups 6 to 12 on the long-form periodic table of the elements. Examples of such a metal ion include respective ions of Ru, Fe, Os, Cu, W, Cr, Mo, Ni, Pd, Pt, Co, Ir, Rh, Re, Mn, and Zn. The metal ion M may be one kind of ion, or two or more kinds of ions.

In the present invention, the metal ion M is preferably Os²⁺, Ru²⁺, or Fe²⁺, more preferably Os²⁺ or Ru²⁺, and particularly preferably Ru²⁺ above all.

In addition, in a state of being incorporated in the photoelectric conversion element, the valence of M may be changed by the redox reaction with the surrounding material in some cases.

In each of Formulae (1) to (3), Ar¹¹ to Ar¹⁴ each represent an aryl group or a heteroaryl group, each having a substituent selected form a substituent group T.

Examples of the aryl group which can be adopted and used as each of Ar¹¹ to Ar¹⁴ include may be a monocyclic aromatic hydrocarbon ring group and a ring group exhibiting aromaticity, formed by fusion of two or more monocyclic hydrocarbon rings (a fused polycyclic aromatic hydrocarbon ring group). Examples of the monocyclic hydrocarbon ring include a monocyclic aromatic hydrocarbon ring, and a hydrocarbon ring not exhibiting aromaticity, such as cyclopentadiene.

The monocyclic aromatic hydrocarbon ring group is not particularly limited, but is preferably a benzene ring group.

The fused polycyclic aromatic hydrocarbon ring group is not particularly limited, but is preferably a group formed by fusion of a benzene ring group and/or a cyclopentadiene ring. In the fused polycyclic aromatic hydrocarbon ring group, the number of ring members of the fused hydrocarbon ring is not particularly limited, but is preferably 4 to 8, and more preferably 5 or 6. Incidentally, the number of the fused hydrocarbon rings is not particularly limited, and is preferably 2 to 5, more preferably 2 or 3, and still more preferably 2. Examples of the fused polycyclic aromatic hydrocarbon ring group include the respective groups of a naphthalene ring, an anthracene ring, a phenanthrene ring, a triphenylene ring, a chrysene ring, a picene ring, a pyrene ring, a fluorene ring, and an azulene ring.

The number of ring-constituting atoms of the aryl group which can be adopted and used as each of Ar¹¹ to Ar¹⁴ is not particularly limited, but is preferably 6 to 30, more preferably 6 to 15, and still more preferably 6 to 13.

Examples of the heteroaryl group which can be adopted and used as each of Ar¹¹ to Ar¹⁴ include a monocyclic aromatic heterocyclic group and a ring group exhibiting aromaticity (fused polycyclic aromatic heterocyclic group) formed by fusion of a plurality of monocycles (including ones not exhibiting aromaticity), including heterocycles. Examples of the monocycle forming the fused polycyclic aromatic heterocyclic group include a monocyclic aromatic heterocycle and a monocyclic hydrocarbon ring. The monocyclic hydrocarbon ring has the same definitions as the monocyclic hydrocarbon ring in the aryl group.

The monocyclic aromatic heterocyclic group is not particularly limited, but is preferably an aromatic heterocyclic group having carbon atoms and heteroatoms (for example, a nitrogen atom, an oxygen atom, a sulfur atom, a silicon atom, a selenium atom, and a phosphorous atom) as a ring-constituting atom. The monocyclic aromatic heterocyclic group is not particularly limited, but is preferably a group with a 5- or 6-membered ring.

Examples of the monocyclic aromatic heterocyclic group include the respective groups of a thiophene ring, a furan ring, a pyrrole ring, a selenophene ring, a thiazole ring, an oxazole ring, an isothiazole ring, an isoxazole ring, an imidazole ring, a pyrazole ring, a thiadiazole ring, an oxadiazole ring, a triazole ring, a silole ring, a phosphole ring, a pyridine ring, a pyrazine ring, a pyrimidine ring, a pyridazine ring, a triazine ring, or a tetrazine ring.

The fused polycyclic aromatic heterocyclic group is not particularly limited, and examples thereof include a monocyclic aromatic heterocyclic group and a ring group bonded with a monocyclic hydrocarbon ring. Examples of the ring group include a ring group formed by fusion of a plurality of monocyclic aromatic heterocycles, and a ring group formed by fusion of a plurality of monocyclic aromatic heterocycles and monocyclic hydrocarbon rings. In the fused polycyclic aromatic heterocyclic group, the number of ring members and the number of monocycles in the fused monocycles are not particularly limited, and are the same as the number of ring members and the number of hydrocarbon rings in the fused polycyclic hydrocarbon rings, and preferred ranges thereof are also the same.

Examples of the fused polycyclic aromatic heterocyclic group include the respective groups of a benzofuran ring, an isobenzofuran ring, a benzothiophene ring, a benzoisothiophene ring, an indazole ring, an indole ring, an isoindole ring, an indolizine ring, a carbazole ring (dibenzopyrrole ring), a quinoline ring, an isoquinoline ring, a benzoxazole ring, a benzisoxazole ring, a benzothiazole ring, a benzisothiazole ring, a benzimidazole ring, a benzotriazole ring, a dibenzofuran ring, a dibenzothiophene ring, a thienopyridine ring, a silafluorene ring (dibenzosilole ring), a thieno[3,2-b]thiophene ring, a thieno[3,4-b]thiophene ring, a trithiophene ring, a cyclopentadithiophene ring, a cyclopentadifuran ring, a benzodifuran ring, a benzodithiophene ring, a dithienopyrrole ring, a dithienofuran ring, and a dithienosilole ring.

The number of ring-constituting atoms of the heteroaryl group which can be adopted and used as each of Ar¹¹ to Ar¹⁴ is not particularly limited, but is preferably 0 to 24, and more preferably 1 to 18.

Ar¹¹ to Ar¹⁴ are each preferably an aryl group, and more preferably a phenyl group.

In each of the metal complex dyes (1) to (3), Ar¹¹ to Ar¹⁴ may be the same as or different from each other, and are preferably the same as each other.

Ar¹¹ to Ar¹⁴ each have a substituent selected from the substituent group T which will be described later. Among those, an alkyl group, an aryl group, a heteroaryl group, an alkoxy group, an aryloxy group, an alkylthio group, an arylthio group, a halogen atom, or a cyano group is preferable, an alkyl group, an aryl group, a heteroaryl group, an alkoxy group, or a halogen atom is more preferable, an alkyl group, an aryl group, an alkoxy group, or a halogen atom is still more preferable, and an alkyl group or an alkoxy group is particularly preferable.

Examples of the alkyl group which can be adopted and used as the substituent that may be contained in each of Ar¹¹ to Ar¹⁴ include a linear alkyl group, a branched alkyl group, and a cyclic (cyclo)alkyl group.

The number of carbon atoms in the linear alkyl group or the branched alkyl group is preferably 1 to 30, more preferably 2 to 26, still more preferably 3 to 20, and particularly preferably 3 to 12. Examples of the linear alkyl group or the branched alkyl group include methyl, ethyl, n-propyl, i-propyl, n-butyl, t-butyl, n-pentyl, 2,2-dimethylpropyl, n-hexyl, cyclohexyl, n-octyl, 2-ethylhexyl, 3-ethylheptyl, 2-butyloctyl, n-decyl, 3,7-dimethyloctyl, isodecyl, s-decyl, n-dodecyl, 2-butyloctyl, n-hexadecyl, isohexadecyl, n-eicosyl, n-hexacosyl, and isooctacosyl.

The number of carbon atoms in the cyclic alkyl group is preferably 3 to 30, more preferably 5 to 30, still more preferably 6 to 26, and particularly preferably 6 to 20. Examples of the cyclic alkyl group include cyclopropyl, cyclopentyl, cyclohexyl, cycloheptyl, and cyclooctyl. The cyclic alkyl group may be fused with an alicycle, an aromatic ring, or a heterocycle.

The alkyl group may further be substituted with a group selected from the substituent group T which will be described later. The alkyl group preferably has a halogen atom, and more preferably a fluorine atom (corresponding to a fluorinated alkyl group) as the substituent. Examples of the fluorinated alkyl group include trifluoromethyl and pentafluoroethyl.

The aryl group which can be adopted and used as the substituent that may be contained in each of Ar¹¹ to Ar¹⁴ has the same definition as that of the aryl group which can be adopted and used as each of Ar¹¹ to Ar¹⁴, but the number of carbon atoms in the aryl group is preferably 6 to 30, more preferably 6 to 10, and particularly preferably 6.

The aryl group may further be substituted with a group selected from the substituent group T which will be described later, and may be preferably substituted with an alkyl group.

The heteroaryl group which can be adopted and used as the substituent that may be contained in each of Ar¹¹ to Ar¹⁴ has the same definition as that of the heteroaryl group which can be adopted and used as each of Ar¹¹ to Ar¹⁴, and preferred examples thereof are also the same.

Examples of the alkoxy group which can be adopted and used as the substituent that may be contained in each of Ar¹¹ to Ar¹⁴ include a linear alkoxy group, a branched alkoxy group, and a cyclic (cyclo) alkoxy group. The alkyl moiety of the alkoxy group has the same definition as that of the alkyl group, and preferred examples thereof are also the same. The number of carbon atoms in the linear or branched alkoxy group is preferably 1 to 30, more preferably 2 to 26, still more preferably 3 to 20, and particularly preferably 3 to 12. The number of carbon atoms in the cyclic alkoxy group is preferably 3 to 30, more preferably 5 to 30, still more preferably 6 to 26, and particularly preferably 6 to 20.

Examples of the linear alkoxy group or branched alkoxy group methoxy, ethoxy, n-propoxy, i-propoxy, n-butoxy, t-butoxy, n-pentoxy, 2,2-dimethylpropoxy, n-hexyloxy, n-octyloxy, 2-ethylhexyloxy, 2-butyloctyloxy, 3,7-dimethyloctyloxy, n-decyloxy, isodecyloxy, s-decyloxy, 2-butyloctyloxy, n-dodecyloxy, n-hexadecyloxy, isohexadecyloxy, n-eicosyloxy, n-hexacosyloxy, and isooctacosyloxy.

Examples of the cyclic alkoxy include cyclopropyloxy, cyclopentyloxy, cyclohexyloxy, cycloheptyloxy, and cyclooctyloxy.

The alkoxy group may further be substituted with a group selected from the substituent group T which will be described later.

Examples of the aryloxy group which can be adopted and used as the substituent that may be contained in each of Ar¹¹ to Ar¹⁴ include a heteroaryloxy group, in addition to an aromatic hydrocarbon ring oxy group. The aromatic hydrocarbon ring has the same definition as an aromatic hydrocarbon ring (a monocyclic aromatic hydrocarbon ring and a fused polycyclic aromatic hydrocarbon ring, each of which forms an aryl group which can be adopted and used as each of Ar¹¹ to Ar¹⁴) (the same shall apply to the arylthio group), which forms each of the aromatic hydrocarbon ring group and the fused polycyclic aromatic hydrocarbon ring group. In addition, the heteroaryl ring has the same definition as each of the monocyclic aromatic heterocycle and the fused polycyclic aromatic heterocycle, each of forms the heteroaryl group which can be adopted and used as each of Ar¹¹ to Ar¹⁴ (the same shall apply to the arylthio group).,

The number of carbon atoms in the aryloxy group is preferably 3 to 30, more preferably 3 to 25, still more preferably 3 to 20, and particularly preferably 3 to 16. Examples of the aryloxy group include phenoxy, naphthoxy, imidazolyloxy, benzimidazolyloxy, pyridin-4-yloxy, pyrimidinyloxy, quinazolinyloxy, purinyloxy, and thiophen-3-yloxy.

The aryloxy group may further be substituted with a group selected from the substituent group T which will be described later.

Examples of the alkylthio group which can be adopted and used as the substituent that may be contained in each of Ar¹¹ to Ar¹⁴ include a linear alkylthio group, a branched alkylthio group, and a cyclic (cyclo) alkylthio group. The alkyl moiety of the alkylthio group has the same definition as that of the alkyl group, and preferred examples thereof are also the same. The number of carbon atoms in the linear or branched alkylthio group is preferably 1 to 30, more preferably 2 to 26, still more preferably 3 to 20, and particularly preferably 3 to 12. The number of carbon atoms in the cyclic alkylthio group is preferably 3 to 30, more preferably 5 to 30, still more preferably 6 to 26, and particularly preferably 6 to 20.

Examples of a linear alkylthio group or a branched alkylthio group include methylthio, ethylthio, n-propylthio, i-propylthio, n-butylthio, t-butylthio, n-pentylthio, 2,2-dimethylpropylthio, n-hexylthio, n-octylthio, 2-ethylhexylthio, 3,7-dimethyloctylthio, n-decylthio, isodecylthio, s-decylthio, n-dodecylthio, 2-butyloctylthio, n-hexadecylthio, isohexadecylthio, n-eicosylthio, n-hexacosylthio, and isooctacosylthio.

Examples of the cyclic alkylthio group include cyclopropylthio, cyclopentylthio, cyclohexylthio, cycloheptylthio, and cyclooctylthio.

The alkylthio group may further be substituted with a group selected from the substituent group T which will be described later.

Examples of the arylthio group which can be adopted and used as the substituent that may be contained in each of Ar¹¹ to Ar¹⁴ include a heteroarylthio group, in addition to an aromatic hydrocarbon ring thio group. The number of carbon atoms in the arylthio group is preferably 3 to 30, more preferably 3 to 25, still more preferably 3 to 20, and particularly preferably 3 to 16. Examples of the arylthio group include phenylthio, naphthylthio, imidazolylthio, benzimidazolylthio, pyridin-4-ylthio, pyrimidinylthio, quinazolinylthio, purinylthio, and thiophen-3-ylthio. As the heterocycle of the heteroarylthio group, a thiophene ring is preferable.

The arylthio group may further be substituted with a group selected from the substituent group T which will be described later.

Examples of the halogen atom which can be adopted and used as the substituent that may be contained in each of Ar¹¹ to Ar¹⁴ include a fluorine atom, a chlorine atom, a bromine atom, and an iodine atom. Among those, a fluorine atom or a chlorine atom is preferable, and a fluorine atom is more preferable.

The substituents other than the respective groups which can be adopted and used as the substituent that may be contained in each of Ar¹¹ to Ar¹⁴ have the same definitions as the respective groups in the substituent group T which will be described later, and preferred examples thereof are also the same.

Each of Ar¹¹ to Ar¹⁴ has a substituent. The number of the substituents is not particularly limited, but is preferably 1 to 4, and more preferably 1 or 2. In a case where the phenyl group has a plurality of substituents or atoms, the substituents or atoms may be the same as or different from each other.

Each of Ar¹¹ to Ar¹⁴ has a substituent. The substitution position is not particularly limited. For example, in a case where each of Ar¹¹ to Ar¹⁴ is a benzene ring group, the position may be any one of an ortho-position (o-), a meta-position (m-), and a para-position (p-) with respect to the ring-constituting carbon atom bonded to an N atom, and is preferably a meta-position (m-) or a para-position (p-). In a case of being substituted with two substituents, the substitution positions are preferably an ortho-position and a para-position, or both meta-positions.

Each of Ar¹¹ to Ar¹⁴ is preferably represented by any one of Formulae (2-1) to (2-5), more preferably represented by Formula (2-1) or (2-2), and still more preferably represented by Formula (2-1).

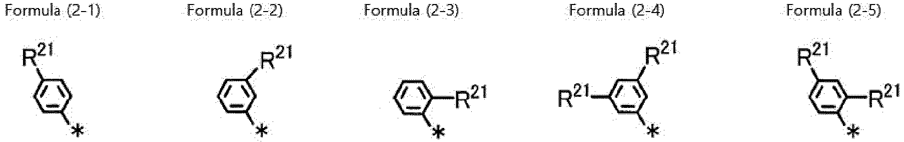

In the formula, ^{∗} represents a bonding moiety to a nitrogen atom.

R²¹ represents a hydrogen atom, an alkyl group, an aryl group, a heteroaryl group, an alkoxy group, or a halogen atom. R²¹ is preferably a hydrogen atom, an alkyl group, an aryl group, an alkoxy group, or a halogen atom, and more preferably a hydrogen atom, an alkyl group, or an alkoxy group.

An alkyl group, an aryl group, a heteroaryl group, an alkoxy group, or a halogen atom which can be adopted and used as R²¹ has the same definition as the substituent which may be contained in each of Ar¹¹ to Ar¹⁴, and preferred examples thereof are also the same.

In Formulae (2-4) and (2-5), two R²¹'s may be the same as or different from each other.

Ar¹¹ and Ar¹², and Ar¹³ and Ar¹⁴ may be directly bonded to each other or via a linking group. The linking group is not particularly limited, and examples thereof include -O-, -S-, -NR^{NR}-, -C(R^{NR})₂-, and -Si(R^{NR})₂-. Here, examples of R^{NR} include a group selected from the substituent group T, and preferably an alkyl group.

In the present invention, it is preferable that Ar¹¹ and Ar¹², and Ar¹³ and Ar¹⁴ are not bonded to each other.

In each of each of the metal complex dyes (1) to (3), Ar¹¹ and Ar¹², and Ar¹³ and Ar¹⁴ may be the same as or different from each other. Further, the amino group having Ar¹¹ and Ar¹² and the amino group having Ar¹³ and Ar¹⁴ may be the same as or different from each other.

In the respective Formulae (1) to (3), L¹ and L² each represent an ethenylene group (-C(R^{L})=C(R^{L})-) or an ethynylene group (-C=C-), are each preferably an ethenylene group, and more preferably both ethenylene groups. The ethenylene group may have a substituent. Examples of the substituent include a group selected from the following substituent group T, and the substituent is preferably an alkyl group or an aryl group. In the ethenylene group, R^{L}'s each represent a hydrogen atom or a substituent (the substituent has the same definition as the substituent which may be contained in ethenylene), and are each preferably a hydrogen atom.

In each of the metal complex dyes (1) to (3), L¹ and L² may be the same as or different from each other.

In each of Formulae (1) to (3), R¹¹ and R¹² each preferably represent an alkyl group, an alkoxy group, an aryl group, an alkylthio group, a heteroaryl group, an amino group, or a halogen atom. Among those, the alkyl group, the alkoxy group, the aryl group, or the halogen atom is preferable, and the alkyl group or the aryl group is more preferable. The alkyl group, the alkoxy group, the aryl group, the alkylthio group, the heteroaryl group, and the halogen atom which can be adopted and used as each of R¹¹ and R¹² have the same definitions as the respective corresponding groups in the substituent which may be contained in each of Ar¹¹ to Ar¹⁴, and preferred examples thereof are also the same. Examples of the amino group which can be adopted and used as each of R¹¹ and R¹² include the amino groups in the substituent group T which will be described later, and preferred examples thereof are also the same. In a case where there are a plurality of R¹¹'s or R¹²'s, the plurality of R¹¹'s and R¹²'s may be the same as or different from each other.

n¹¹ and n¹² each represent an integer of 0 to 3, and are preferably 0 or 1, and more preferably 0.

In each of Formulae (1) to (3), R¹³ and R¹⁴ each represent an alkyl group, an alkoxy group, an aryl group, an alkylthio group, a heteroaryl group, an amino group, or a halogen atom. Among those, the alkyl group, the alkoxy group, the aryl group, or the halogen atom is preferable, and the alkyl group or the aryl group is more preferable. The alkyl group, the alkoxy group, the aryl group, the alkylthio group, the heteroaryl group, and the halogen atom which can be adopted and used as each of R¹³ and R¹⁴ have the same definitions as the respective corresponding groups in the substituent which may be contained in each of Ar¹¹ to Ar¹⁴, and preferred examples thereof are also the same. Examples of the amino group which can be adopted and used as each of R¹³ and R¹⁴ include the amino groups in the substituent group T which will be described later, and preferred examples thereof are also the same. In a case where there are a plurality of R¹³'s or R¹⁴'s, the plurality of R¹³'s and R¹⁴'s may be the same as or different from each other.

n¹³ and n¹⁴ each represent an integer of 0 to 4, and are preferably an integer of 0 to 2, and more preferably 0 or 1.

In each of the metal complex dyes (1) to (3), a pyridine ring group having a group including -L¹-benzene ring group-N(Ar¹¹)(Ar¹²) and a pyridine ring group having a group including -L²-benzene ring group-N(Ar¹³)(Ar¹⁴) may be the same ring groups or different ring groups, and they are preferably the same ring groups.

In each of the metal complex dyes (1) to (3), it is preferable that the bipyridine ligand having L¹ and L² do not have an acidic group. The acidic group which will be described later.

In each of Formulae (1) to (3), M¹ and M² each represent any one of a proton, a metal cation, and a non-metal cation other than the proton. M¹ and M² are each preferably a non-metal cation from the viewpoints of improvement of the photoelectric conversion efficiency and reduction in the deviation, and preferably a proton or a metal cation from the viewpoint of durability.

In each of the metal complex dyes (1) to (3), in a case where a proton, a metal cation, and a non-metal cation exist in mixture as M¹ and M², any of M¹ and M² may be the proton, the metal cation, or the non-metal cation. Further, each of the metal complex dyes may be a metal complex dye in which any one of M¹ and M² is a metal cation or a non-metal cation, or may also be a mixture of a metal complex dye in which M¹ and M² are both protons and a metal complex dye in which M¹ and M² are both metal cations or non-metal cations.

In a case where protons, metal cations, and non-metal cations exist in mixture as M¹ and M², the amount of the existing metal cations and non-metal cations is not particularly limited. The amount of the existing metal cations and non-metal cations in each of the metal complex dyes is the same as the amount in all of the existing metal complex dyes (1) to (3) (the presence ratio (molar amount) of the metal cations and non-metal cations in the dye composition), and a preferred range thereof is also the same. It is more preferable that the amount of the existing metal cations and non-metal cations in each of the metal complex dyes satisfies the amount in all of the existing metal complex dyes (1) to (3).

The metal cation which can be adopted and used as each of M¹ and M² is not particularly limited, but examples thereof include an alkali metal ion, an alkaline earth metal ion, and a metal complex ion. Among those, the alkali metal ion or the alkaline earth metal ion is preferable, the alkali metal ion is more preferable, the lithium ion, the sodium ion, or the potassium ion is still more preferable, and the sodium ion or the potassium ion is particularly preferable.

The non-metal cation which can be adopted and used as each of M¹ and M² is not particularly limited, but examples thereof include inorganic or organic ammonium ions (for example, tetraalkylammonium ions, trialkylammonium ions, dialkylammonium ions, monoalkylammonium ions, ammonium ions, and pyridinium ions), phosphonium ions (for example, tetraalkylphosphonium ions and alkyltriphenylphosphonium ions), pyridinium ions, imidazolium ions, amidinium ions, and guanidinium ions. Among those, organic ammonium ions (quaternary ammonium ions such as tetraethylammonium ions, tetrabutylammonium ions, tetrahexylammonium ions, tetraoctylammonium ions, tetradecylammonium ions, tetradodecylammonium ions, trimethylbenzylammonium ions, and tris(hydroxymethyl)methylammonium ions; tertiary ammonium ions such as triethylammonium ions, tributylammonium ions, triisobutylammonium ions, tris(2-ethylhexyl)ammonium ions, tribenzylammonium ions, diisopropylethylammonium ions, diethylbenzylammonium ions, and diisopropyl(1-hydroxyethyl)ammonium ions; secondary ammonium ions such as diisopropylammonium ions and dibutylammonium ions; primary ammonium ions such as butylammonium ions; and the like), pyridinium ions, imidazolium ions, and amidinium ions are preferable, organic ammonium ions, pyridinium ions, and imidazolium ions are more preferable, and organic ammonium ions are still more preferable.

In each of the metal complex dyes, a bipyridine ligand having a COOM¹ group and a COOM² group do not need to have a substituent in each of the pyridine rings. As the substituent, a group other than the acidic group is preferable, and a group selected from the substituent group T which will be described later is more preferable.

In each of the metal complex dyes (1) to (3), M¹ and M² may be the same as or different from each other.

In Formulae (2) and (3), X's each represent an isothiocyanate group (-NCS, an isothiocyanate anion) or a thiocyanate group (-SCN, a thiocyanate anion).

In the present invention, in the metal complex dye (2), if one monodentate ligand is -SCN, the other monodentate ligand X may be either ―SCN or -NCS. In the metal complex dye (2), a metal complex dye in which X is ―NCS and a metal complex dye in which X is -SCN are in the relationship of bond isomers to each other. By being used with the metal complex dye (1) in combination, the effect of the present invention is exhibited by either of the metal complex dye in which X is ―NCS and the metal complex dye in which X is ―SCN. Accordingly, in the present invention, it is not necessary to clearly distinguish these metal complex dyes.

These shall also apply to the metal complex dye (3).

In the present invention, in a case of the isomers of the metal complex dye (2) are distinguished, a metal complex dye in which X is ―NCS is referred to as a metal complex dye (2A), and a metal complex dye in which X is ―SCN is referred to as a metal complex dye (2B), for simplicity. Similarly, in the metal complex dye (3), the metal complex dyes are also referred to as a metal complex dye (3A) and a metal complex dye (3B), respectively, for simplicity.

The metal complex dyes (1) to (3) may be either metal complex dyes in which the structures (each of Ar¹¹ to Ar¹⁴, L¹, L², R¹¹ to R¹⁴, n¹¹ to n¹⁴, X, and M¹ and M²) other than the monodentate ligands represented by the respective formulae are the same as each other (metal complex dyes in which two bipyridine ligands are the same as each other) or metal complex dyes in which the structures are different from each other. In addition, the metal complex dyes (1) to (3) may be either of metal complex dyes in which the respective M's are the same as each other and metal complex dyes in which the respective M's are different from each other.

In a case of the metal complex dyes where the structures other than the monodentate ligands are different from each other, they are preferably, for example, metal complex dyes in which at least one of Ar¹¹ to Ar¹⁴, R¹¹ to R¹⁴, or M¹ and M² are different from each other.

The metal complex dyes (1) to (3) can each be identified by high performance liquid chromatography (HPLC). The measurement condition for HPLC is not particularly limited as long as it is a condition under which the peaks of (retention times) of the respective metal complex dyes are separated from each other, but examples thereof include the following conditions. Accordingly, the contents of the metal complex dyes (1) to (3) in the dye composition which will be described later can be determined.

Examples of the measurement condition for HPLC include the condition with a column: YMC-Triart C18 (150 mm × 4.6 mm I.D., particle diameter of 5 µm, pore diameter of 12 nm), an oven temperature of 40°C, a detection wavelength of 254 nm, a flow rate of 1.0 mL/min, and an eluent oftetrahydrofuran (THF)/water/trifluoroacetic acid (TFA), using a high performance liquid chromatography device (Shimadzu Corporation).

In the metal complex dye (2), the metal complex dyes (2A) and (2B) can be distinguished (identified) by the analysis of X-ray structures, or the like. This shall also apply to the metal complex dye (3).

The metal complex dyes (1) to (3) can each be synthesized by, for example, the methods described in JP2001-291534A, JP2013-072079A, and JP2008-021496A, the patent publications regarding solar cells, known methods, or the methods equivalent thereto.

The metal complex dyes (1) to (3) have a maximum absorption wavelength in each of solutions, which is preferably in a range from 300 to 1,000 nm, more preferably in a range from 350 to 950 nm, and particularly preferably in a range from 370 to 900 nm.

### <Substituent group T>

In the present invention, preferred examples of the substituent include the groups selected from the following substituent group T. An acidic group is not included in the substituent group T. The acidic group is a substituent which has a dissociative proton and has a pKa of 11 or less. Examples of the acidic group include a carboxyl group, a sulfo group, a phosphonyl group, a phosphoryl group, and a boric acid group. The pKa of the acidic group can be determined in accordance with the "SMD/M05-2x/6-31G*" method described in J. Phys. Chem. A2011, 115, pp. 6641-6645.

Incidentally, in the present specification, in a case where there is only a simple description of a substituent, the description is intended to refer to this substituent group T, and in a case where each of the groups, for example, an alkyl group is merely described, preferable range and specific examples for the corresponding group for the substituent group T are applied.

Moreover, in the present specification, in a case where an alkyl group is described as distinguishable from a cyclic (cyclo) alkyl group, the alkyl group is used to mean inclusion of both of a linear alkyl group and a branched alkyl group. On the other hand, in a case where an alkyl group is not described as distinguishable from a cycloalkyl group (a case where an alkyl group is simply described and a case where there is no particular description), the alkyl group is used to mean any of a linear alkyl group, a branched alkyl group, and a cycloalkyl group. This shall also apply to a group (an alkoxy group, an alkylthio group, an alkenyloxy group, and the like) including a group (an alkyl group, an alkenyl group, an alkynyl group, and the like) which can adopt and use a cyclic structure, and a compound including a group which can adopt and use a cyclic structure. In a case where a cyclic skeleton cannot be formed, the lower limit of the number or atoms of a group that forms the cyclic skeleton is 3 or more, and preferably 5 or more, irrespective of the lower limit of the number of atoms, which will be described later with respect to a group which can adopt and use the structure.

In the following description of the substituent group T, for example, a group with a linear or branched structure and a group with a cyclic structure are sometimes separately described for clarification of both groups, such as an alkyl group and a cycloalkyl group.

Examples of the groups included in the substituent group T include the following groups, or groups formed by combination of a plurality of the following groups:
an alkyl group (preferably an alkyl group having 1 to 20 carbon atoms, and more preferably an alkyl group having 1 to 12 carbon atoms, for example, methyl, ethyl, isopropyl, t-butyl, pentyl, heptyl, 1-ethylpentyl, benzyl, 2-ethoxyethyl, 1-carboxymethyl, and trifluoromethyl), an alkenyl group (preferably an alkenyl group having 2 to 20 carbon atoms, and more preferably an alkenyl group having 2 to 12 carbon atoms, for example, vinyl, allyl, and oleyl), an alkynyl group (preferably an alkynyl group having 2 to 20 carbon atoms, and more preferably an alkynyl group having 2 to 12 carbon atoms, for example, ethynyl, butynyl, and phenylethynyl), a cycloalkyl group (preferably a cycloalkyl group having 3 to 20 carbon atoms), an cycloalkenyl group (preferably a cycloalkenyl group having 5 to 20 carbon atoms), an aryl group (preferably an aryl group having 6 to 26 carbon atoms, and more preferably an aryl group having 6 to 10 carbon atoms, for example, phenyl, 1-naphthyl, 4-methoxyphenyl, 2-chlorophenyl, 3-methylphenyl, difluorophenyl, and tetrafluorophenyl), and a heterocyclic group (having at least one of an oxygen atom, a sulfur atom, or a nitrogen atom as a ring-constituting atom, and preferably having 2 to 20 carbon atoms), with a 5- or 6-membered heterocyclic group being more preferable. Examples of the heterocycle include an aromatic heterocyclic group (heteroaryl group) and an aliphatic heterocyclic group. Examples of the aromatic heterocyclic group include the following groups. For example, 2-pyridyl, 4-pyridyl, 2-imidazolyl, 2-benzimidazolyl, 2-thiazolyl, and 2-oxazolyl), an alkoxy group (preferably an alkoxy group having 1 to 20 carbon atoms, and more preferably an alkoxy group having 1 to 12 carbon atoms, for example, methoxy, ethoxy, isopropyloxy, and benzyloxy), an alkenyloxy group (preferably an alkenyloxy group having 2 to 20 carbon atoms, and more preferably an alkenyloxy group having 2 to 12 carbon atoms), an alkynyloxy group (preferably an alkynyloxy group having 2 to 20 carbon atoms, and more preferably an alkynyloxy group having 2 to 12 carbon atoms), a cycloalkyloxy group (preferably a cycloalkyloxy group having 3 to 20 carbon atoms), an aryloxy group (preferably an aryloxy group having 6 to 26 carbon atoms), a heterocyclic oxy group (preferably a heterocyclic oxy group having 2 to 20 carbon atoms),
an alkoxycarbonyl group (preferably an alkoxycarbonyl group having 2 to 20 carbon atoms), a cycloalkoxycarbonyl group (preferably a cycloalkoxycarbonyl group having 4 to 20 carbon atoms), an aryloxycarbonyl group (preferably an aryloxycarbonyl group having 6 to 20 carbon atoms), an amino group (preferably an amino group having 0 to 20 carbon atoms including an alkylamino group, an alkenylamino group, an alkynylamino group, a cycloalkylamino group, a cycloalkenylamino group, an arylamino group, and a heterocyclic amino group, for example, amino, N,N-dimethylamino, N,N-diethylamino, N-ethylamino, N-allylamino, N-(2-propynyl)amino, N-cyclohexylamino, N-cyclohexenylamino, anilino, pyridylamino, imidazolylamino, benzimidazolylamino, thiazolylamino, benzothiazolylamino, and triazinylamino), a sulfamoyl group (preferably a sulfamoyl group having 0 to 20 carbon atoms, preferably an alkyl-, cycloalkyl-, or aryl-sulfamoyl group), an acyl group (preferably an acyl group having 1 to 20 carbon atoms), an acyloxy group (preferably an acyloxy group having 1 to 20 carbon atoms), a carbamoyl group (preferably a carbamoyl group having 1 to 20 carbon atoms, preferably an alkyl-, cycloalkyl-, or aryl-carbamoyl group),
an acylamino group (preferably an acylamino group having 1 to 20 carbon atoms), a sulfonamido group (preferably a sulfonamido group having 0 to 20 carbon atoms, and preferably an alkyl-, cycloalkyl-, or aryl-sulfonamido group), an alkylthio group (preferably an alkylthio group having 1 to 20 carbon atoms, and more preferably an alkylthio group having 1 to 12 carbon atoms, for example, methylthio, ethylthio, isopropylthio, and benzylthio), a cycloalkylthio group (preferably a cycloalkylthio group having 3 to 20 carbon atoms), an arylthio group (preferably an arylthio group having 6 to 26 carbon atoms), an alkyl-, cycloalkyl-, or aryl-sulfonyl group (preferably an alkyl-, cycloalkyl-, or aryl-sulfonyl group having 1 to 20 carbon atoms),
a silyl group (preferably a silyl group having 1 to 20 carbon atoms, preferably an alkyl-, aryl-, alkoxy-, and aryloxy-substituted silyl group), a silyloxy group (preferably a silyloxy group having 1 to 20 carbon atoms, preferably an alkyl-, aryl-, alkoxy-, and aryloxy-substituted silyloxy group), a hydroxyl group, a cyano group, a nitro group, and a halogen atom (for example, a fluorine atom, a chlorine atom, a bromine atom, and iodine atom).

Examples of the group selected from the substituent group T more preferably include an alkyl group, an alkenyl group, a cycloalkyl group, an aryl group, a heterocyclic group, an alkoxy group, a cycloalkoxy group, an aryloxy group, an alkylthio group, a cycloalkylthio group, an arylthio group, an alkoxycarbonyl group, a cycloalkoxycarbonyl group, an amino group, an acylamino group, a cyano group, and a halogen atom; and particularly preferably include an alkyl group, an alkenyl group, a heterocyclic group, an alkoxy group, an alkylthio group, an alkoxycarbonyl group, an amino group, an acylamino group, and a cyano group.

In a case where the compound, the substituent, or the like includes an alkyl group, an alkenyl group, or the like, these may be substituted or unsubstituted. Further, in a case where the compound, the substituent, or the like includes an aryl group, a heterocyclic group, or the like, these may be a monocycle or a fused ring, and may be substituted or unsubstituted.

Specific examples of the metal complex dyes (1) to (3) are shown in the following description and Examples, but the present invention is not limited to these metal complex dyes.

In the following specific examples, the metal complex dyes (1) to (3) in which an "L¹-D¹ group" and an "L²-D² group" are the same as each other are collectively described (having the same serial numbers attached). However, in the present invention, the metal complex dyes (2) and (3) which are used in combination with the metal complex dye (1) are each not limited to metal complex dyes in which the "L¹-D¹ group" and the "L²-D² group" are the same as each other, and may also be metal complex dyes in which the "L¹-D¹ group" and the "L²-D² group" are different from each other as described above. For example, the following metal complex dye D-1-1 and the following metal complex dye D-2-2A can be used in combination.

In the following specific examples, M¹ and M² are each selected from the following optional elements, and a combination of M¹ and M² may be any of 16 combinations. M¹ and M² are also each preferably, in addition to the following 4 kinds, a tetrahexylammonium ion, a triethylammonium ion, or a tributylammonium, which are preferably taken as M¹ and M² below as options.

In the following specific examples, ^{∗} of D¹ and D² represents a bonding moiety to L¹ or L². Further, ^{∗} of L¹ and L² represents a bonding moiety to D¹ or D², and ^{∗∗} represents a bonding moiety to a pyridine ring. In the following specific examples, Me represents methyl and TBA represents a tetrabutylammonium ion.

Moreover, in the following specific examples, the metal complex dyes are represented by "D-X" and "n". Here, X represents a serial number depending on the kind of D¹ and D² of the following formulae, and n represents metal complex dye names (1) to (3B).

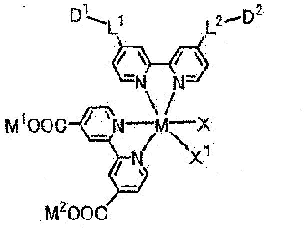

| D-X | n | X | X¹ | L¹, L² | D¹ | D² | M¹ | M² |
|---|---|---|---|---|---|---|---|---|
| D-1 | 1 | -NCS | -NCS | **-CH=CH-* | 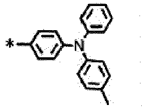 | 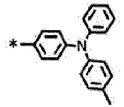 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-2 | 1 | -NCS | -NCS | ∗∗-CH=CH-∗ | 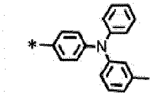 | 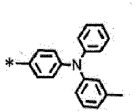 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-3 | 1 | -NCS | -NCS | **-CH=CH-* | 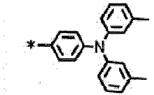 | 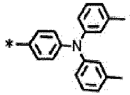 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-4 | 1 | -NCS | -NCS | **-CH=CH-* | 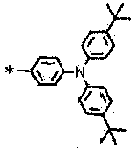 | 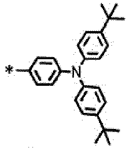 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-5 | 1 | -NCS | -NCS | ∗∗-CH=CH-∗ | 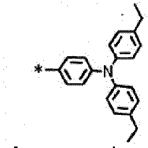 | 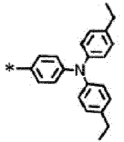 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-6 | 1 | -NCS | -NCS | ∗∗-CH=CH-∗ | 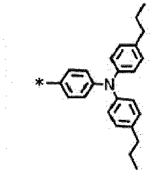 | 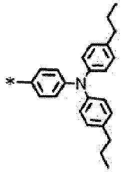 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-7 | 1 | -NCS | -NCS | ∗∗-CH=CH-∗ | 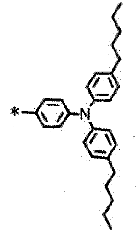 | 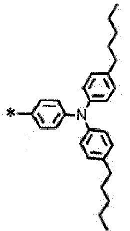 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-8 | 1 | -NCS | -NCS | ∗∗-CH=CH-∗ | 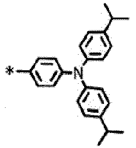 | 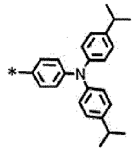 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-9 | 1 | -NCS | -NCS | ∗∗-CH=CH-∗ | 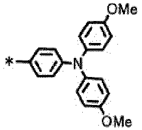 | 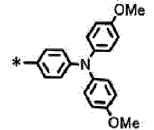 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-10 | 1 | -NCS | -NCS | ∗∗-CH=CH-∗ | 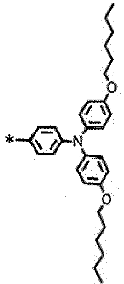 | 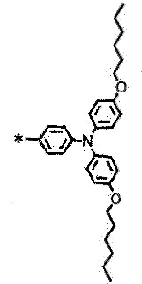 | H, K, Na or TBA | H.K.Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-11 | 1 | -NCS | -NCS | ∗∗-CH=CH-∗ | 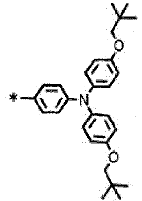 | 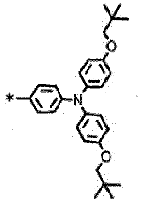 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-12 | 1 | -NCS | -NCS | **-CH=CH-* | 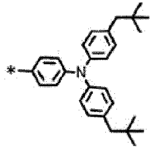 | 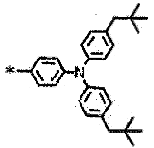 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-13 | 1 | -NCS | -NCS | ∗∗-CH=CH-∗ | 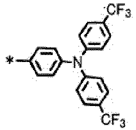 | 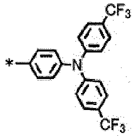 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-14 | 1 | -NCS | -NCS | ∗∗-CH=CH-∗ | 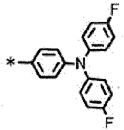 | 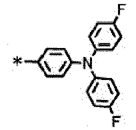 | N, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-15 | 1 | -NCS | -NCS | **-CH=CH-* | 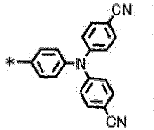 | 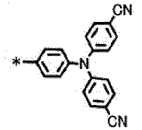 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-16 | 1 | -NCS | -NCS | ∗∗-CH=CH-∗ | 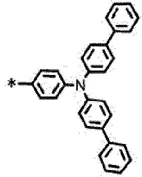 | 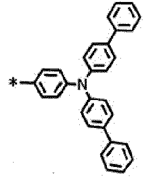 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-17 | 1 | -NCS | -NCS | ∗∗-CH=CH-∗ | 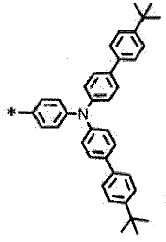 | 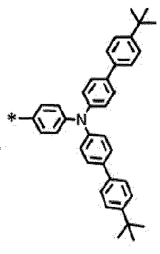 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-18 | 1 | -NCS | -NCS | ∗∗-CH=CH-∗ | 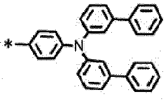 | 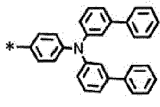 | H, K,Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-19 | 1 | -NCS | -NCS | ∗∗-CH=CH-∗ | 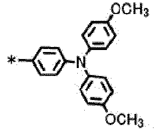 | 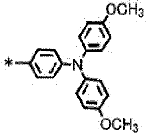 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-20 | 1 | -NCS | -NCS | **-CH=CH-* | 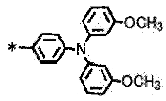 | 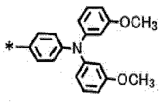 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-21 | 1 | -NCS | -NCS | ∗∗-CH=CH-∗ | 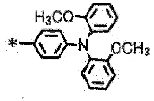 | 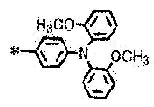 | H, K, Na or TBA | H, K,Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-22 | 1 | -NCS | -NCS | **-CH=CH-* | 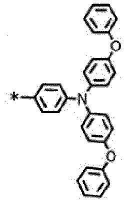 | 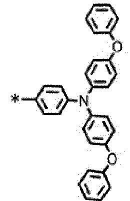 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-23 | 1 | -NCS | -NCS | **-CH=CH-* | 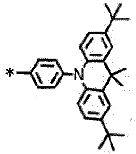 | 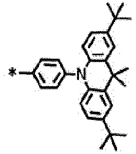 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-24 | 1 | -NCS | -NCS | ∗∗-CH=CH-∗ | 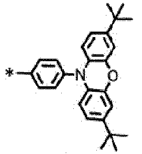 | 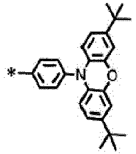 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-25 | 1 | -NCS | -NCS | ∗∗-CH=CH-∗ | 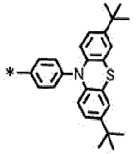 | 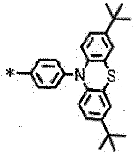 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-26 | 1 | -NCS | -NCS | **-CH=CH-* | 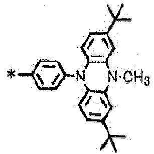 | 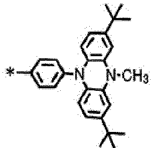 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-27 | 1 | -NCS | -NCS | ∗∗-CH=CH-∗ | 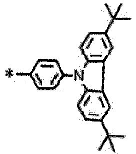 | 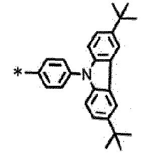 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-28 | 1 | -NCS | -NCS | ∗∗-CH=CH-∗ | 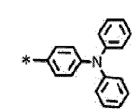 | 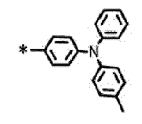 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-29 | 1 | -NCS | -NCS | ∗∗-CH=CH-∗ | 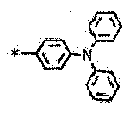 | 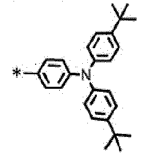 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-30 | 1 | -NCS | -NCS | **-CH=CH-* | 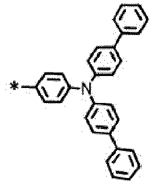 | 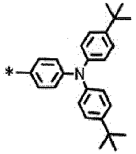 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-31 | 1 | -NCS | -NCS | ∗∗-C≡C-∗ | 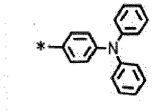 | 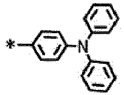 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-32 | 1 | -NCS | -NCS | ∗∗-C≡C-∗ | 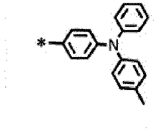 | 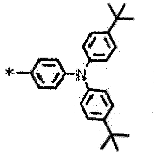 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-33 | 1 | -NCS | -NCS | ∗∗-C≡C-∗ | 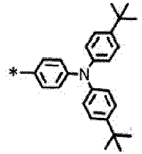 | 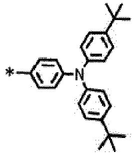 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-34 | 1 | -NCS | -NCS | ∗∗-C≡C-∗ | 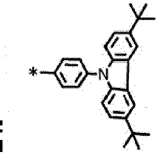 | 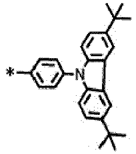 | H, K, Na or TBA | H,K, Na or TBA |
| | | -NCS | -SCN | | | | | |
| | 2B | -SCN | -SCN | | | | | |
| | 3A | -NCS | -CN | | | | | |
| | 3B | -SCN | -CN | | | | | |
| D-35 | 1 | -NCS | -NCS | ∗∗-C≡C-∗ | 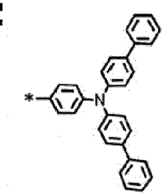 | 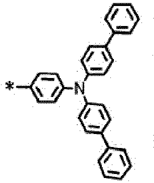 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-36 | 1 | -NCS | -NCS | ∗∗-C≡C-∗ | 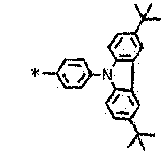 | 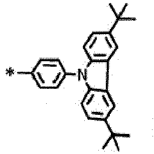 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-37 | 1 | -NCS | -NCS | ∗∗-C≡C-∗ | 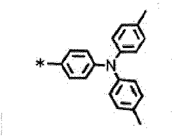 | 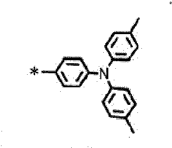 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-38 | 1 | -NCS | -NCS | ∗∗-C≡C-∗ | 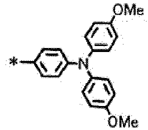 | 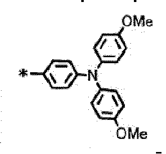 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-39 | 1 | -NCS | -NCS | **-CH=CH-* | 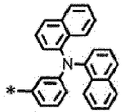 | 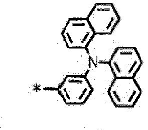 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-40 | 1 | -NCS | -NCS | ∗∗-CH=CH-∗ | 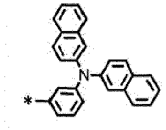 | 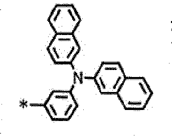 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-41 | 1 | -NCS | -NCS | ∗∗-CH=CH-∗ | 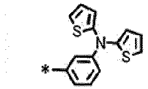 | 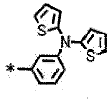 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |
| D-42 | 1 | -NCS | -NCS | **-CH=CH-* | 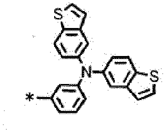 | 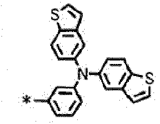 | H, K, Na or TBA | H, K, Na or TBA |
| | 2A | -NCS | -SCN | | | | | |
| | 2B | -SCN | -SCN | | | | | |
| | 3A | -NCS | -CN | | | | | |
| | 3B | -SCN | -CN | | | | | |

### <Dye composition>

The dye composition of the present invention includes the metal complex dye represented by Formula (1), and at least one metal complex dye selected from the group consisting of the metal complex dye represented by Formula (2) and the metal complex dye represented by Formula (3). The dye composition of the present invention preferably includes the metal complex dye (1) and the metal complex dye (2), and further, may also include the metal complex dye (3).

In the present invention, in a case where the dye composition including the metal complex dye (1), and at least one of the metal complex dye (2) or (3) is used, the crystallinity of the metal complex dye is lowered, as compared with a case of using the metal complex dye (1) singly. As a result, in the production of the photoelectric conversion element, it is thought that the aggregation among the metal complex dyes in the step of adsorbing the metal complex dye onto the semiconductor fine particles can be suppressed. In particular, if a nitrile solvent, an alcohol solvent, a hydrocarbon solvent, or a ketone solvent is used as the solvent in the dye composition, the affinity of the metal complex dye with the solvent increases, and thus, it is possible to coat the surface of the semiconductor fine particles with better efficiency while suppressing the aggregation among the metal complex dyes. As a result, it is thought that a photoconductor layer with reduction in an inefficient process (for example, a leakage current) can be formed.

The metal complex dyes (1) to (3) contained in the dye composition of the present invention, and specific examples thereof are each the same as described above.

The combination of the metal complex dyes (1) to (3) contained in the dye composition of the present invention is not particularly limited, and it may be either a combination of metal complex dyes having the same structures other than the monodentate ligand represented by one of the formulae above, or a combination of metal complex dyes having different structures other than the monodentate ligand. Incidentally, it may be either a combination of metal complex dyes having the same M's or a combination of metal complex dyes having different M's.

In the dye composition of the present invention, the content ratio (molar ratio) of the metal complex dye (1), the metal complex dye (2), and the metal complex dye (3) is not particularly limited. This content ratio cannot be routinely determined by M, Ar¹¹ to Ar¹⁴, L¹, L², R¹¹ to R¹⁴, n¹¹ to n¹⁴, M¹, M², or the like, but it can be set to, for example, the following content ratio.

The content ratio (molar ratio) of the metal complex dye (1) to the metal complex dye (2) is preferably 1.0/0.1 to 2, more preferably 1.0/0.1 to 1.5, and still more preferably 1.0/0.1 to 1, in terms of the molar ratio of the metal complex dye (1)/the metal complex dye (2). In the present invention, even when the content ratio of the metal complex dye (2) is reduced to, for example, 0.01, the deviation can be reduced, and the photoelectric conversion efficiency can also be improved. In this case, the content ratio (molar ratio) is preferably 1.0/0.01 to 2, more preferably 1.0/0.01 to 1.5, and still more preferably 1.0/0.01 to 1, in terms of the molar ratio of the metal complex dye (1)/the metal complex dye (2).

The content ratio (molar ratio) of the metal complex dye (1) to the metal complex dye (3) is preferably 1.0/0 to 0.5, and more preferably 1.0/0 to 0.1, in terms of the molar ratio of the metal complex dye (1)/the metal complex dye (3).

For the content ratio (molar ratio) of the metal complex dye (1) to the metal complex dye (2) to the metal complex dye (3), the content ratio of the metal complex dye (1) to the metal complex dye (2) and the content ratio of the metal complex dye (1) to the metal complex dye (3) can each be appropriately combined. For example, the molar ratio of the metal complex dye (1)/the metal complex dye (2)/the metal complex dye (3) is preferably 1.0/0.1 to 2/0 to 0.5, more preferably 1.0/0.1 to 1.5/0 to 0.5, and still more preferably 1.0/0.1 to 1/0 to 0.1. As described above, the content ratio of the metal complex dye (2) can further be reduced, and in this case, the content ratio (molar ratio) is preferably 1.0/0.01 to 2/0 to 0.5, more preferably 1.0/0.01 to 1.5/0 to 0.5, and still more preferably 1.0/0.01 to 1/0 to 0.1, in terms of the molar ratio of the metal complex dye (1)/the metal complex dye (2)/the metal complex dye (3).

In the dye composition of the present invention, in a case where the metal complex dyes (1) to (3) has a proton, and at least one of a metal cation or a non-metal cation as M¹ and M², as for the presence ratio of the metal cation and the non-metal cation, the metal cation and the non-metal cation are included in the amount of preferably 0.000001 to 1.5 moles, more preferably 0.000001 to 1.2 moles, and still more preferably 0.000001 to 1.0 mole, and particularly preferably 0.01 to 1.0 mole, in the total molar amount (2.0 moles) of M¹ and M² contained in the metal complex dyes (1) to (3).

The proton may be contained in any of metal complex dyes, or may be contained in a plurality of metal complex dyes. Further, any one of M¹ and M² may be a proton, or both of them may be protons.

The dye composition of the present invention preferably includes a solvent (in the present invention, a dye composition including a solvent is also referred to as a dye solution). Details of the solvent and the dye solution will be described later.

Next, preferred aspects of the main members of the photoelectric conversion element and the dye-sensitized solar cell will be described.

### <Electrically Conductive Support>

The electrically conductive support is not particularly limited as long as it has electrical conductivity and is capable of supporting a photoconductor layer 2 or the like. The electrically conductive support is a material having electrically conductivity, for example, preferably an electrically conductive support 1 formed of a metal which will be described later, or an electrically conductive support 41 having a glass or plastic substrate 44 and a transparent electrically-conductive film 43 formed on the surface of the substrate 44.

Above all, the electrically conductive support 41 having the transparent electrically-conductive film 43 of a metal oxide on the surface of the substrate 44 is more preferable. Such the electrically conductive support 41 is obtained by applying an electrically conductive metal oxide on the surface of the substrate 44 to form the transparent electrically-conductive film 43. Examples of the substrate 44 formed of plastics include the transparent polymer films described in paragraph No. 0153 of JP2001-291534A. Further, as a material which forms the substrate 44, ceramics (JP2005-135902A) or electrically conductive resins (JP2001-160425A) can be used, in addition to glass and plastics. As the metal oxide, tin oxide (TO) is preferable, and indium-tin oxide (tin-doped indium oxide; ITO), and fluorine-doped tin oxide (FTO) such as tin oxide which has been doped with fluorine are particularly preferable. In this case, the coating amount of the metal oxide is preferably 0.1 to 100 g, per square meter of the surface area of the substrate 44. In a case of using the electrically conductive support 41, it is preferable that light is incident from the substrate 44.

It is preferable that the electrically conductive supports 1 and 41 are substantially transparent. The expression, "substantially transparent", means that the transmittance of light (at a wavelength of 300 to 1,200 nm) is 10% or more, preferably 50% or more, and particularly preferably 80% or more.

The thickness of the electrically conductive supports 1 and 41 is not particularly limited, but is preferably 0.05 µm to 10 mm, more preferably 0.1 µm to 5 mm, and particularly preferably 0.3 µm to 4 mm.

In a case of including the transparent electrically-conductive film 43, the thickness of the transparent electrically-conductive film 43 is preferably 0.01 to 30 µm, more preferably 0.03 to 25 µm, and particularly preferably 0.05 to 20 µm.

It is preferable that the electrically conductive supports 1 and 41 have a metal oxide coating film including a metal oxide on the surface thereof. As the metal oxide, the metal oxide that forms the transparent electrically-conductive film 43 or the metal oxide mentioned as the metal oxide as the semiconductor fine particles which will be described later can be used, with the metal oxide mentioned as the semiconductor fine particles being preferable. The metal oxide may be the same as or different from the metal oxide that forms the transparent electrically-conductive film 43 or the metal oxide mentioned as the semi-conductive fine particles. The metal oxide coating film is usually formed on a thin film, and preferably has a thickness of 0.01 to 100 nm, for example. A method for forming the metal oxide coating film is not particularly limited, and examples thereof include the same method as the method for forming a layer formed by the semiconductor fine particles, which will be described later. For example, a liquid including a metal oxide or a precursor thereof (for example, a halide and an alkoxide) can be applied and heated (calcined) to form a metal oxide coating film.

The electrically conductive supports 1 and 41 may be provided with a light management function at the surface, and may have, for example, the anti-reflection film having a high refractive index oxide film and a low refractive index oxide film alternately laminated described in JP2003-123859A, and the light guide function described in JP2002-260746A on the surface.

### <Photoconductor Layer>

As long as the photoconductor layer has semiconductor fine particles 22 carrying the dye 21, and an electrolyte, it is not particularly limited in terms of the other configurations. Preferred examples thereof include the photoconductor layer 2 and the photoconductor layer 42.

### - Semiconductor Fine Particles (Layer Formed by Semiconductor Fine Particles) -

The semiconductor fine particles 22 are preferably fine particles of chalcogenides of metals (for example, oxides, sulfides, and selenides) or of compounds having perovskite type crystal structures. Preferred examples of the chalcogenides of metals include oxides of titanium, tin, zinc, tungsten, zirconium, hafnium, strontium, indium, cerium, yttrium, lanthanum, vanadium, niobium, or tantalum, cadmium sulfide, and cadmium selenide. Preferred examples of the compounds having perovskite type crystal structures include strontium titanate and calcium titanate. Among those, titanium oxide (titania), zinc oxide, tin oxide, and tungsten oxide are particularly preferable.

Examples of the crystal structure of titania include structures of an anatase type, a brookite type, and a rutile type, with the structures of an anatase type and a brookite type being preferable. A titania nanotube, nanowire, or nanorod may be used singly or in mixture with titania fine particles.

The particle diameter of the semiconductor fine particles 22 is expressed in terms of an average particle diameter using a diameter in a case where a projected area is converted into a circle, and is preferably 0.001 to 1 µm as primary particles, and 0.01 to 100 µm as an average particle diameter of dispersions. Examples of the method for coating the semiconductor fine particles 22 on the electrically conductive supports 1 or 41 include a wet method, a dry method, and other methods.

It is preferable that the semiconductor fine particles 22 have a large surface area so that they may adsorb a large amount of the dye 21. For example, in a state where the semiconductor fine particles 22 are coated on the electrically conductive support 1 or 41, the surface area is preferably 10 times or more, and more preferably 100 times or more, with respect to the projected area. The upper limit of this value is not particularly limited, and the upper limit is usually approximately 5,000 times. In general, as the thickness of the layer (having the same definition as a photoconductor layer) formed by the semiconductor fine particles increases, the amount of dye 21 that can be carried per unit area increases, and therefore, the light absorption efficiency increases. However, since the diffusion distance of generated electrons increases correspondingly, the loss due to charge recombination also increases.

Although a preferred thickness of the layer formed by the semiconductor fine particles may vary depending on the utility of the photoelectric conversion element, it is typically 0.1 to 100 µm. In a case of using the photoelectric conversion element as a dye-sensitized solar cell, the thickness of the photoconductor layer is more preferably 1 to 50 µm, and still more preferably 3 to 30 µm.

The layer of the semiconductor fine particles 22 can be formed by, for example, applying the semiconductor fine particles 22 onto the electrically conductive support 1 or 41, and then calcining them at a temperature of 100°C to 800°C for 10 minutes to 10 hours. Thus, the semiconductor fine particles can be adhered to each other, which is thus preferable.

The coating amount of the semiconductor fine particles 22 per square meter of the surface area of the electrically conductive support 1 or 41 is preferably 0.5 to 500 g, and more preferably 5 to 100 g.

The film-forming temperature is preferably 60°C to 600°C in a case where glass is used as a material for the electrically conductive support 1 or substrate 44.

### - Light-Scattering Layer -

In the present invention, the light-scattering layer is different from the semiconductor layer 45 formed of the semiconductor fine particles 22 in a view that the light-scattering layer has a function of scattering incident light.

In the dye-sensitized solar cell 20, the light-scattering layer 46 preferably contains rod-shaped or plate-shaped metal oxide fine particles. Examples of the metal oxide particles to be used in the light-scattering layer 46 include particles of the chalcogenides (oxides) of the metals, described above as the compound which forms semiconductor fine particles. In a case of providing the light-scattering layer 46, it is preferable that the thickness of the light-scattering layer is set to 10% to 50% of the thickness of the photoconductor layer 42.

The light-scattering layer 46 is preferably the light-scattering layer described in JP2002-289274A.

### - Metal Oxide Coating Film -

In the present invention, semiconductor fine particles which form a photoconductor layer (including a case of forming the semiconductor layer 45 and the light-scattering layer 46), and preferably have a metal oxide coating film on the surface thereof As the metal oxide which forms a metal oxide coating film, the metal oxide mentioned as the semiconductor fine particles can be used, and the metal oxide may be the same as or different from the semiconductor fine particles. This metal oxide coating film is usually formed on a thin film, and preferably has a thickness of 0.1 to 100 nm, for example. In the present invention, in a case where the semiconductor fine particles have a metal oxide coating film, the metal complex dye is adsorbed on the semiconductor fine particles via the metal oxide coating film. A method for forming the metal oxide coating film is as described above.

In the present invention, in particular, it is preferable that the surfaces of the electrically conductive support and the semiconductor fine particles each have the metal oxide coating film. In this case, the respective metal oxide coating films may be formed of the same or different kinds of metal oxides.

### - Dye -

In the photoelectric conversion element 10 and the dye-sensitized solar cell 20, the metal complex dye represented by Formula (1), and at least one metal complex dye selected from the group consisting of the metal complex dye represented by Formula (2) and the metal complex dye represented by Formula (3) are used as a sensitizing dye. Each of the metal complex dyes represented by Formulae (1) to (3) is the same as described above.

In the metal complex dyes adsorbed onto the semiconductor fine particles, the content ratios (adsorption amounts) of the metal complex dye (1), the metal complex dye (2), and the metal complex dye (3) are not particularly limited. The content ratios are preferably the same as those in the above-described dye composition of the present invention.

In the present invention, a dye that can be used in combination with the metal complex dyes represented by Formulae (1) to (3) is not particularly limited, but examples thereof include a Ru complex dye, a squarylium cyanine dye, an organic dye, a porphyrin dye, and a phthalocyanine dye, which are other than the metal complex dyes represented by Formulae (1) to (3). As the dye which can be used with the other, the Ru complex dye, the squarylium cyanine dye, or the organic dye is preferable.

The amount of the dye to be used cannot be routinely determined, but is preferably 0.01 to 100 millimoles, more preferably 0.1 to 50 millimoles, and particularly preferably 0.1 to 10 millimoles, per square meter of the surface area of the electrically conductive support 1 or 41. Further, the amount of the dye 21 to be adsorbed onto the semiconductor fine particles 22 is preferably 0.001 to 1 millimole, and more preferably 0.1 to 0.5 millimoles, with respect to 1 g of the semiconductor fine particles 22. By setting the amount of the dye to such a range, the sensitization effect on the semiconductor fine particles 22 is sufficiently obtained.

In a case where the metal complex dyes represented by Formulae (1) to (3) are used in combination with another dye, the ratio of the total mass of the respective metal complex dyes represented by Formulae (1) to (3)/the mass of another dye is preferably 95/5 to 10/90, more preferably 95/5 to 50/50, still more preferably 95/5 to 60/40, particularly preferably 95/5 to 65/35, and most preferably 95/5 to 70/30.

After the dye is carried on the semiconductor fine particles 22, the surface of the semiconductor fine particles 22 may be treated using an amine compound. Preferred examples of the amine compound include pyridine compounds (for example, 4-t-butylpyridine and polyvinylpyridine). These may be used as they are in a case where they are liquids, or may be used in a state where they are dissolved in an organic solvent.

### - Co-Adsorbent -

In the present invention, it is preferable that the semiconductor fine particles carry a co-adsorbent, together with each of the metal complex dyes represented by Formulae (1) to (3), or with other dyes to be used in combination, if necessary. As such a co-adsorbent, a co-adsorbent having one or more acidic groups (preferably carboxyl groups or salts thereof) is preferable, and examples thereof include a fatty acid and a compound having a steroid skeleton.

The fatty acid may be a saturated fatty acid or an unsaturated fatty acid, and examples thereof include a butanoic acid, a hexanoic acid, an octanoic acid, a decanoic acid, a hexadecanoic acid, a dodecanoic acid, a palmitic acid, a stearic acid, an oleic acid, a linoleic acid, and a linolenic acid.

Examples of the compound having a steroid skeleton include cholic acid, glycocholic acid, chenodeoxycholic acid, hyocholic acid, deoxycholic acid, lithocholic acid, and ursodeoxycholic acid, among which cholic acid, deoxycholic acid, and chenodeoxycholic acid are preferable; and chenodeoxycholic acid is more preferable.

Preferred examples of the co-adsorbent material include the compounds represented by Formula (CA) described in paragraph Nos. 0125 to 0129 of JP2014-82187A.

By making the co-adsorbent adsorbed onto the semiconductor fine particles 22, the co-adsorbent has an effect of suppressing the inefficient association of the metal complex dye and an effect of preventing reverse electron transfer from the surface of the semiconductor fine particles to the redox system in the electrolyte. The amount of the co-adsorbent to be used is not particularly limited, and from the viewpoint of exhibiting the above effects effectively, the amount is preferably 1 to 200 moles, more preferably 10 to 150 moles, and particularly preferably 10 to 50 moles, per mole of the metal complex dye.

It is preferable that a short circuit-preventing layer is formed between the electrically conductive support 1 or 41 and the photo conductor layer 2 or 42 so as to prevent reverse current due to a direct contact between the electrolyte included in the photoconductor layer 2 or 42 and the electrically conductive support 1 or 41.

In addition, it is preferable to use a spacer S (see Fig. 2) or a separator so as to prevent contact between the light-receiving electrode 5 or 40 and the counter electrode 4 or 48.

### <Charge Transfer Layer>

The charge transfer layers 3 and 47 used in the photoelectric conversion element of the present invention are layers having a function of complementing electrons for the oxidized forms of the dye 21, and are provided between the light-receiving electrode 5 or 40 and the counter electrode 4 or 48.

The charge transfer layers 3 and 47 include electrolytes. Here, the expression, "the charge transfer layer includes an electrolyte", is meant to encompass both of an aspect in which the charge transfer layer consists only of an electrolyte and an aspect in which the charge transfer layer contains an electrolyte and materials other than the electrolyte.

The charge transfer layers 3 and 47 may be any of a solid form, a liquid form, a gel form, or a mixture thereof.

### - Electrolyte -

Examples of the electrolyte include a liquid electrolyte having a redox pair dissolved in an organic solvent, and a so-called gel electrolyte in which a molten salt containing a redox pair and a liquid having a redox pair dissolved in an organic solvent are impregnated in a polymer matrix. Among those, in a view of photoelectric conversion efficiency, a liquid electrolyte is preferable.

Examples of the redox pair include a combination of iodine and an iodide (preferably an iodide salt or an iodide ionic liquid, and more preferably lithium iodide, tetrabutylammonium iodide, tetrapropylammonium iodide, and methylpropylimidazolium iodide), a combination of an alkylviologen (for example, methylviologen chloride, hexylviologen bromide, and benzylviologen tetrafluoroborate) and a reductant thereof, a combination of a polyhydroxybenzene (for example, hydroquinone and naphthohydroquinone) and an oxidized form thereof, a combination of a divalent iron complex and a trivalent iron complex (for example, a combination of potassium ferricyanide and potassium ferrocyanide), and a combination of a divalent cobalt complex and a trivalent cobalt complex. Among those, a combination of iodine and an iodide, or a combination of a divalent cobalt complex and a trivalent cobalt complex is preferable, and a combination of iodine and an iodide is particularly preferable.

As the cobalt complex, the complex represented by Formula (CC) described in paragraph Nos. 0144 to 0156 of JP2014-82189A.

In a case where a combination of iodine and iodide is used as an electrolyte, it is preferable that an iodide salt of a nitrogen-containing aromatic cation of a 5- or 6-membered ring is additionally used.

The organic solvent which is used in a liquid electrolyte and a gel electrolyte is not particularly limited, but is preferably an aprotic polar solvent (for example, acetonitrile, propylene carbonate, ethylene carbonate, dimethylformamide, dimethylsulfoxide, sulfolane, 1,3-dimethylimidazolinone, and 3-methyloxazolidinone).

In particular, as the organic solvent which is used for a liquid electrolyte, a nitrile compound, an ether compound, an ester compound, or the like is preferable, a nitrile compound is more preferable, and acetonitrile or methoxypropionitrile is particularly preferable.

As a molten salt or a gel electrolyte, those described in paragraph No. 0205 and paragraph Nos. 0208 to 0213 of JP2014-139931A.

The electrolyte may also contain an aminopyridine compound, a benzimidazole compound, an aminotriazole compound, an aminothiazole compound, an imidazole compound, an aminotriazine compound, a urea compound, an amide compound, a pyrimidine compound, and a heterocycle including no nitrogen, in addition to pyridine compounds such as 4-t-butylpyridine, as an additive.

Moreover, a method of controlling the moisture content of the electrolytic solution may be employed in order to enhance the photoelectric conversion efficiency. Preferred examples of the method of controlling the moisture content include a method of controlling a concentration, and a method of coexisting a dehydrating agent with other components. The moisture content (content ratio) of the electrolytic solution is preferably adjusted to 0% to 0.1% by mass.

Iodine can also be used as a clathrate compound of iodine with cyclodextrin. Furthermore, a cyclic amidine may be used, or an antioxidant, a hydrolysis inhibitor, a decomposition inhibitor, or zinc iodide may also be added.

A solid-state charge transport layer such as a p-type semiconductor or a hole transport material, for example, CuI and CuNCS, may be used in place of the liquid electrolyte and the quasi-solid-state electrolyte as described above. Moreover, the electrolytes described in Nature, vol. 486, p. 487 (2012) and the like may also be used. For a solid-state charge transport layer, an organic hole transport material may be used. With regard to the organic hole transport material, those described in paragraph No. 0214 of JP2014-139931A.

The redox pair serves as an electron carrier, and therefore, it is preferably contained at a certain concentration. The concentration of the redox pair in total is preferably 0.01 mol/L or more, more preferably 0.1 mol/L or more, and particularly preferably 0.3 mol/L or more. In this case, the upper limit is not particularly limited, but is usually approximately 5 mol/L.

### <Counter Electrode>

The counter electrodes 4 and 48 preferably work as a positive electrode in a dye-sensitized solar cell. The counter electrodes 4 and 48 usually have the same configurations as the electrically conductive support 1 or 41, but in a configuration in which strength is sufficiently maintained, a substrate 44 is not necessarily required.

Examples of the metal which form the counter electrode include platinum (Pt), gold (Au), nickel (Ni), copper (Cu), silver (Ag), indium (In), ruthenium (Ru), palladium (Pd), rhodium (Rh), iridium (Ir), osmium (Os), and aluminum (Al).

A preferred structure of the counter electrodes 4 and 48 is a structure having a high charge collecting effect. At least one of the electrically conductive support 1 or 41 and the counter electrode 4 or 48 should be substantially transparent so that light may reach the photoconductor layers 2 and 42. In the dye-sensitized solar cell of the present invention, the electrically conductive support 1 or 41 is preferably transparent to allow solar light to be incident from the side of the electrically conductive support 1 or 41. In this case, the counter electrodes 4 and 48 more preferably have light-reflecting properties. As the counter electrodes 4 and 48 of the dye-sensitized solar cell, glass or plastic on which a metal or an electrically conductive oxide has been deposited is preferable, and glass on which platinum has been deposited is particularly preferable.

The film thickness of the counter electrode is not particularly limited, and is preferably 0.01 to 100 µm, more preferably 0.01 to 10 µm, and particularly preferably 0.01 to 1 µm.

In the dye-sensitized solar cell, a lateral side of the cell is preferably sealed with a polymer, an adhesive, or the like in order to prevent evaporation of components.

The dye-sensitized solar cell of the present invention is constituted with the above-mentioned photoelectric conversion element. For example, as shown in Fig. 1, the electrically conductive support and the counter electrode of photoelectric conversion element are connected with an external circuit 6 to form a dye-sensitized solar cell. Known external circuits can be used as the external circuit 6 without particular limitation.

### [Method for Producing Photoelectric Conversion Element and Dye-Sensitized Solar Cell]

The photoelectric conversion element and the dye-sensitized solar cell of the present invention are each preferably produced, using the dye composition (dye solution) of the present invention.

The dye solution of the present invention is formed by dissolving the metal complex dye (1) and at least one metal complex dye of the metal complex dyes (2) and (3) in a solvent, and may also include other components, if necessary.

Examples of the solvent to be used include the solvents described in JP2001-291534A, but are not particularly limited thereto. In the present invention, an organic solvent is preferable, and an alcohol solvent, an amide solvent, a nitrile solvent, a ketone solvent, a hydrocarbon solvent, and a mixed solvent of two or more kinds of these solvents are more preferable. As the mixed solvent, a mixed solvent of an alcohol solvent and a solvent selected from an amide solvent, a nitrile solvent, a ketone solvent, and a hydrocarbon solvent is preferable; a mixed solvent of an alcohol solvent and an amide solvent, a mixed solvent of an alcohol solvent and a hydrocarbon solvent, or a mixed solvent of an alcohol solvent and a nitrile solvent is more preferable; and a mixed solvent of an alcohol solvent and an amide solvent, or a mixed solvent of an alcohol solvent and a nitrile solvent are particularly preferable. Specifically, a mixed solvent of at least one kind of methanol, ethanol, propanol, and t-butanol, and at least one kind of dimethylformamide and dimethylacetamide, or a mixed solvent of at least one kind of methanol, ethanol, propanol, and t-butanol, and acetonitrile is preferable.

The dye composition (dye solution) preferably contains a co-adsorbent, and as the co-adsorbent, the aforementioned co-adsorbent is preferable.

Here, the dye solution of the present invention is preferably one in which the concentration of the metal complex dye or the co-adsorbent have been adjusted so that the dye solution can be used as it is during production of the photoelectric conversion element or the dye-sensitized solar cell. In the present invention, the dye solution of the present invention preferably contains 0.001% to 0.1% by mass in total of the metal complex dyes (1) to (3) of the present invention. The amount of the co-adsorbent to be used is the same as described above.

For the dye solution, a dye solution having a low moisture content ratio is preferable in a view of dye adsorption. For example, the moisture content is preferably adjusted to 0% to 0.1% by mass, at least during the use. The moisture content ratio can be adjusted in an ordinary method, at least during the use.

In the present invention, it is preferable to manufacture a photoconductor layer by making a metal complex dye (dye composition) of the metal complex dye (1) and at least one metal complex dye of the metal complex dyes (2) and (3) carried on the surface of the semiconductor fine particles, using a dye composition, and preferably a dye solution. That is, the photoconductor layer is preferably formed by applying (including a dipping method) the dye composition onto the semiconductor fine particles provided on the electrically conductive support, followed by drying and curing.

By further providing a charge transfer layer, a counter electrode, or the like for a light-receiving electrode including the photoconductor layer as manufactured above, the photoelectric conversion element or the dye-sensitized solar cell of the present invention can be obtained.

The dye-sensitized solar cell can be produced by connecting an external circuit 6 with the electrically conductive support 1 and the counter electrode 4 of the photoelectric conversion element thus manufactured.

### EXAMPLES

Hereinafter, the present invention will be described in more detail, based on Examples, but the present invention is not limited thereto.

### Example 1 (Synthesis of Metal Complex Dye)

The structures of the metal complex dyes D-E1 to D-E11 synthesized in the present Examples are shown below.

In Examples, metal complex dyes D-E1-1 to D-E1-3 may be collectively referred to a metal complex dye D-E1 in some cases. This shall also apply to a case of metal complex dyes D-E2 to D-E11.

Each of the metal complex dyes D-E4-1 to 3 is represented by a metal complex dye of each of Formulae (1) to (3) in which M¹ is a potassium ion and M² is a proton, but may be the metal complex dye in which M¹ is a proton and M² is a potassium ion or may be a mixture of the metal complex dye in which M¹ is a potassium ion and M² is a hydrogen atom, and the metal complex dye in which M¹ is a hydrogen atom and M² is a potassium ion. This shall also apply to a case of metal complex dye D-E5 to D-E11.

Incidentally, in the metal complex dyes D-E1 to D-E11, X represents -NCS or -SCN, and in the following metal complex dyes, Et represents ethyl, ⁿBu represents n(normal)-butyl, ¹Bu represents i(iso)-butyl, and ⁿHex represents n(normal)-hexyl.

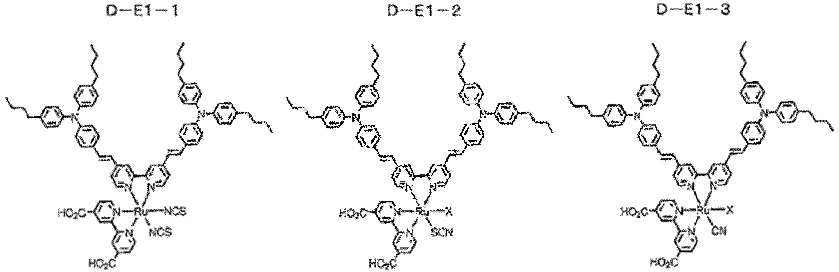

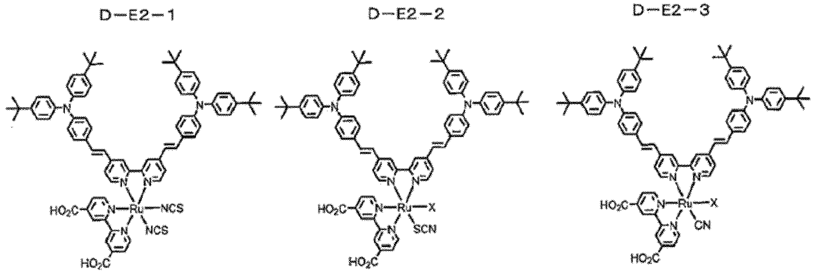

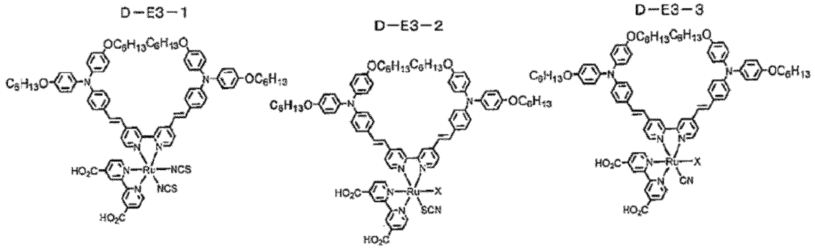

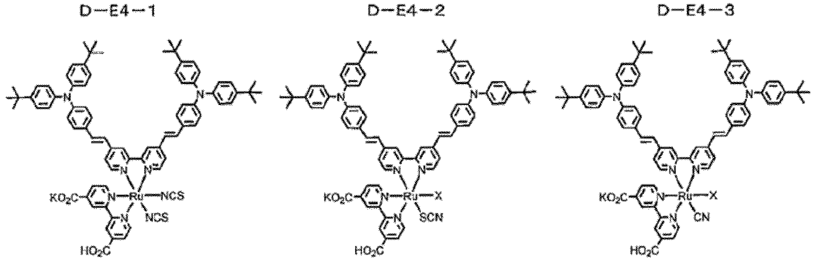

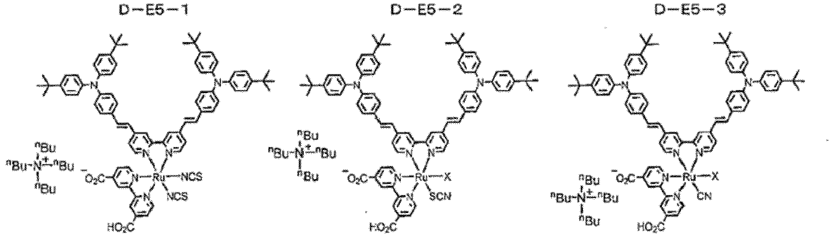

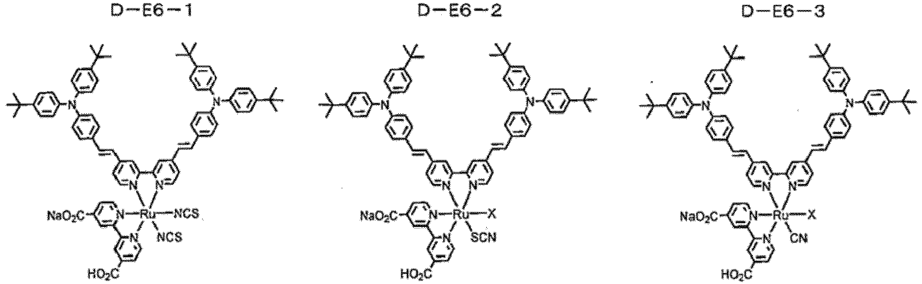

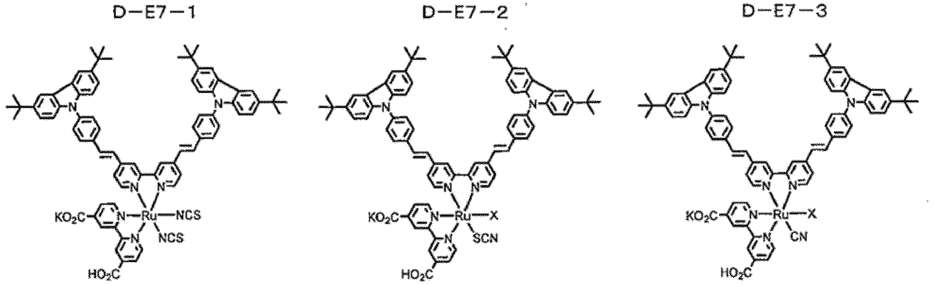

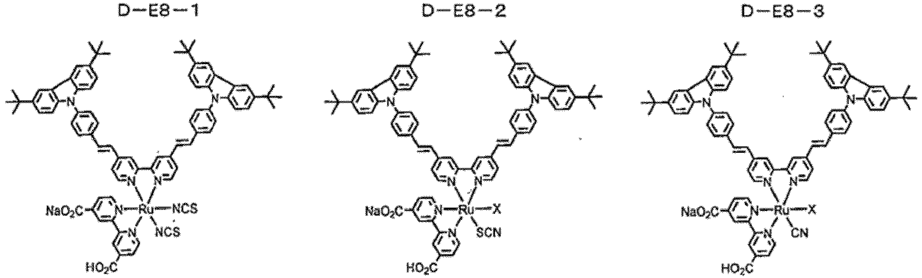

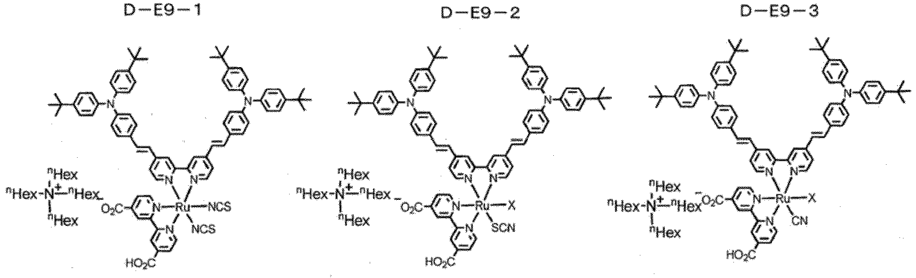

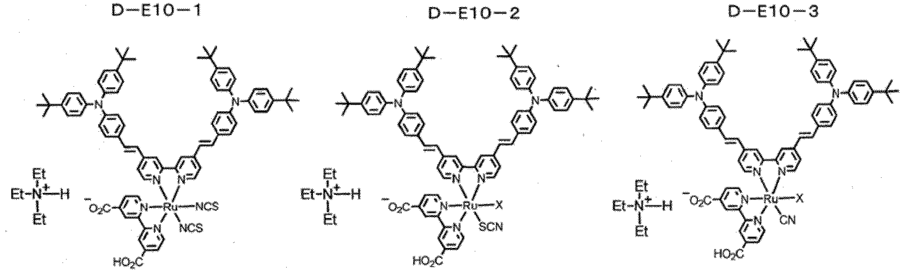

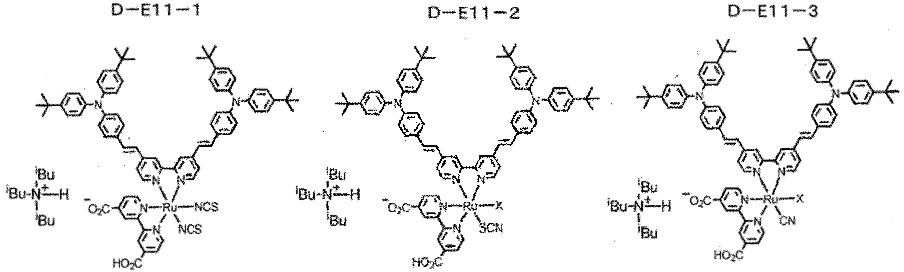

Hereinafter, a method for synthesizing the metal complex dye of the present invention will be described in detail, but the starting materials, the dye intermediates, and the synthesis routes are not limited thereto.

In the present invention, a room temperature means 25°C.

### (Synthesis of Metal Complex Dyes D-E2-1 to D-E2-3)

According to the method of the following scheme, metal complex dyes D-E2-1 to D-E2-3 were synthesized. In the scheme, Et represents ethyl, ^{t}Bu represents tertiary butyl, and Ac represents acetyl.

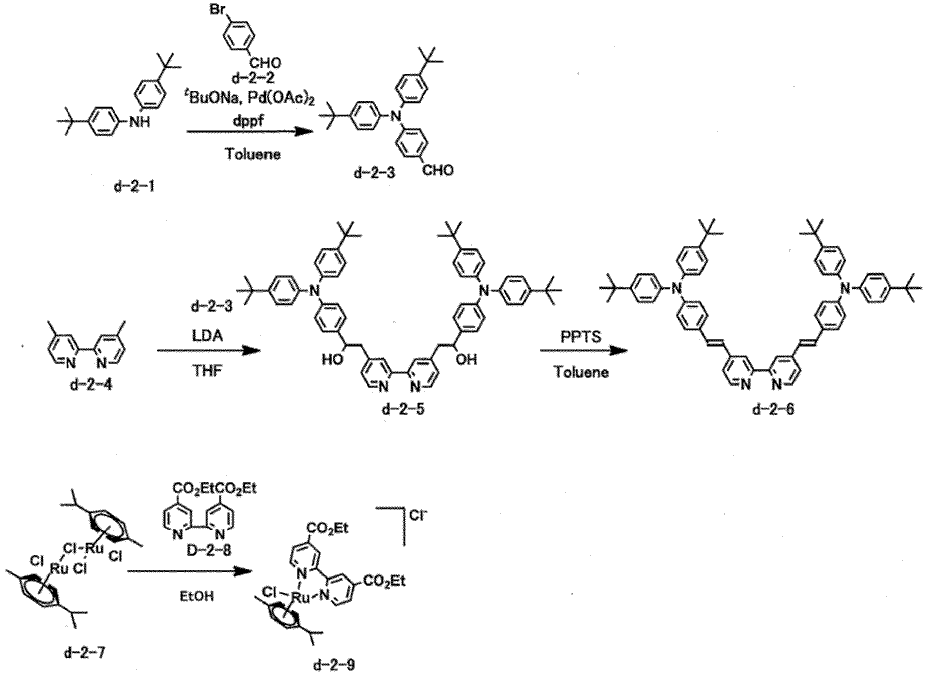

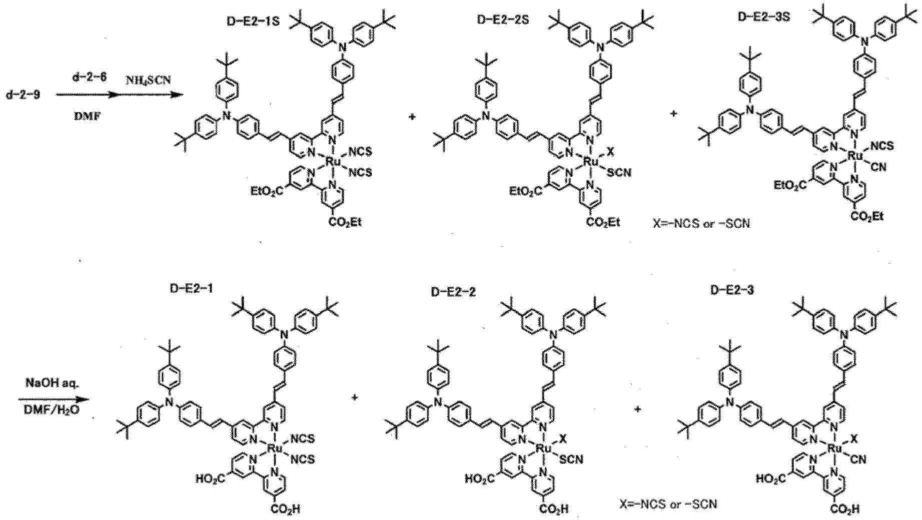

### (i) Synthesis of Compound d-2-3

50 g of a compound d-2-1, 34.5 g of a compound d-2-2, and 20.5 g of tert-butoxysodium were stirred in 500 mL of toluene at room temperature, and the mixture was degassed. 2.46 g of dppf(1,1'-bis(diphenylphosphino)ferrocene) and 1 g of palladium (II) acetate were added thereto, and the mixture was degassed. Thereafter, the obtained mixed solution was stirred at 100°C for 1 hour, and left to be cooled. Then, to the obtained mixture were added 500 mL of water, 100 mL of ethyl acetate, and 30 mL of methanol, so as to perform and the mixture was subjected to extraction and liquid separation. Saturated saline was added to the liquid-separated organic layer, and the mixture was subjected to liquid separation. The obtained organic layer was filtered over Celite and the filtrate was concentrated. The obtained crude purified product was purified by silica gel column chromatography to obtain 50 g of a compound d-2-3.

### (ii) Synthesis of Compound d-2-6

4.5 g of a compound d-2-4 was dissolved in 135 mL of tetrahydrofuran (THF) at -10°C in a nitrogen gas atmosphere, 25.7 mL of a 2 M (mol/L) lithium diisopropylamide (LDA) solution was added dropwise thereto, and the mixture was stirred for 10 minutes. Thereafter, to the obtained reaction solution was added dropwise a solution in which 19.8 g of the compound d-2-3 had been dissolved in 68 mL of THF, and the mixture was stirred at -5°C for 10 minutes, and further stirred at room temperature for 40 minutes. To the obtained liquid was added 150 mL of a saturated aqueous ammonium chloride solution, the mixture was subjected to liquid separation, and the organic layer was concentrated and dried.

A crude purified product including the obtained compound d-2-5, 12.3 g of pyridinium paratoluenesulfonic acid (PPTS) was added to 300 mL of toluene, and the mixture was heated and refluxed for 1 hour in a nitrogen gas atmosphere. To the obtained liquid were added ethyl acetate, water, and saturated sodium bicarbonate, the mixture was subjected to liquid separation, and the organic layer was concentrated. The obtained crude purified product was purified by silica gel column chromatography to obtain 11 g of a compound d-2-6.

### (iv) Synthesis of Compound d-2-9

30.6 g of the compound d-2-7 and 30.0 g of the compound d-2-8 were heated and stirred for 2 hours in ethanol (EtOH), and then concentrated to obtain 60.6 g of a compound d-2-9.

### (v) Synthesis of Compounds D-E2-1S to D-E2-3S

1 g of the compound d-2-9 and 1.48 g of the compound d-2-6 were heated and stirred at 150°C for 7 hours in 20 mL of N,N-dimethylformamide (DMF). Thereafter, to the obtained liquid was added 3.7 g of ammonium thiocyanate, and the mixture was stirred at 130°C for 5 hours. The obtained reaction solution was concentrated and then water was added thereto. The mixture was filtered and the precipitate was washed with diethyl ether. The crude purified product obtained as a precipitate was purified by silica gel column chromatography to obtain 1.3 g of a compound D-E2-1S, 0.1 g of a compound D-E2-2S, and 0.01 g of a compound D-E2-3S, respectively.

### (vi) Synthesis of Metal Complex Dyes D-E2-1 to D-E2-3

To 1.3 g of the compound D-E2-1S was added 80 mL of DMF, 4 mL of water, and 1.6 mL of a 3 N aqueous sodium hydroxide solution, and the mixture was stirred at 30°C for 1 hour. The mixture was adjusted to pH 3.0 by the dropwise addition of a 1 N aqueous trifluoromethanesulfonic acid solution. The mixture was filtered to obtain 1.1 g of a metal complex dye D-E2-1 as a precipitate.

In the same manner as for the metal complex dye D-E2-1, metal complex dyes D-E2-2 and D-E2-3 were synthesized.

The structures of the obtained metal complex dyes D-E2-1 to D-E2-3 were confirmed from mass spectrum (MS) measurement results in Table 1. These can be specified as separate peaks by means of HPLC. As one example of the measurement condition for HPLC, the following conditions can be mentioned, and in the present examples, the following conditions were used for the confirmation.

HPLC Measurement Condition:
Column: YMC-Triart C18 (150 mm × 4.6 mm I.D., particle diameter of 5 µm, pore diameter of 12 nm)
Liquid A: 0.1% TFA, 40% THF/60% H₂O (volume ratio)
Liquid B: 0.1% TFA, 100% THF (volume ratio)
Time program: (0 to 20 min) Bconc. 30% to 80%(gradient), (20 to 30 min) Bconc. 30%
Flow rate: 1.0 mL/min
Oven temperature: 40°C
Detection wavelength 254 nm
Sample injection amount: 5 µL
Retention time: metal complex dye D-E2-1: 13.2 to 13.5 min
   metal complex dye D-E2-2: 12.7 min
   metal complex dye D-E2-3: 10.9 min

Here, for the metal complex dyes D-E2-2 and D-E2-3, the metal complex dye 2A or 2B is not distinguished, and the metal complex dye 3A or 3B is not distinguished.

### (vii) Synthesis of Metal Complex Dye D-E4

0.1 g of the metal complex dye D-E2-1 was stirred at room temperature in 5 mL of methanol. An aqueous potassium hydroxide solution at the amount of molar equivalent to the metal complex dye D-E2-1 was added thereto, and the mixture was stirred for 1 hour. The reaction solution was subjected to bubbling with nitrogen gas to distill off the solvent, and dried to obtain 0.1 g of a metal complex dye D-E4-1.

In the same manner as the synthesis of the metal complex dye D-E4-1, metal complex dyes D-E4-2 and D-E4-3 were synthesized (in the metal complex dye D-E4, the presence ratio of the potassium ions is 1.0 mole with respect to the total molar amount of M¹ and M²).

With regard to the metal complex dyes D-E4-1 to D-E4-3, HPLC measurement was carried out in the same manner as for the metal complex dye D-E2. The retention times of the metal complex dyes D-E4-1 to D-E4-3 are shown below.

Retention time: metal complex dye D-E4-1: 13.2 to 13.5 min
metal complex dye D-E4-2: 12.6 to 13.0 min
metal complex dye D-E4-3: 10.9 min

### (Synthesis of Metal Complex Dyes D-E1, D-E3, and D-E5 to D-E11)

In the same manner as the synthesis of the metal complex dyes D-E2-1 to D-E2-3, and D-E4-1 to D-E4-3, metal complex dyes D-E1-1 to D-E1-3, D-E3-1 to D-E3-3, D-E5-1 to D-E5-3, D-E6-1 to D-E6-3, D-E7-1 to D-E7-3, and D-E8-1 to D-E8-3 were each synthesized.

With regard to the metal complex dyes D-E1-1 to D-E1-3, D-E5-1 to D-E5-3, and D-E6-1 to D-E6-3, HPLC measurement was carried out in the same manner as for the metal complex dye D-E2, and the same results as the retention times of the metal complex dyes D-E2-1 to D-E2-3 were obtained. The retention times of D-E3-1 to D-E3-3, D-E7-1 to D-E7-3 and D-E8-1 to D-E8-3 were sequentially the same as the retention times of the metal complex dyes D-E2-1 to D-E2-3.

In the same manner as the synthesis of the metal complex dyes D-E4-1 to D-E4-3, metal complex dyes D-E9-1 to D-E9-3, D-E10-1 to D-E10-3, and D-E11-1 to D-E11-3 were each synthesized.

With regard to the metal complex dyes D-E9-1 to D-E9-3, D-E10-1 to D-E10-3, and D-E11-1 to D-E11-3, HPLC measurement was carried out in the same manner as for the metal complex dye D-E2, and the same results as the retention times of the metal complex dyes D-E2-1 to D-E2-3 were obtained.

The respective metal complex dyes thus synthesized were confirmed from the MS measurement results in Table 1.

**[Table 1]**

| Table 1 | |
|---|---|
| Metal complex dye | MS (ESI⁺) |
| D-E1-1 | MS (ESI⁺) m/z: 1381.5 ([M+H]⁺) |
| D-E1-2 | MS (ESI⁺) m/z: 1381.5 ([M+H]⁺) |
| D-E1-3 | MS (ESI⁺) m/z: 1349.5 ([M+H]⁺) |
| D-E2-1 | MS (ESI⁺) m/z: 1381.5 ([M+H]⁺) |
| D-E2-2 | MS (ESI⁺) m/z: 1381.5 ([M+H]⁺) |
| D-E2-3 | MS (ESI⁺) m/z: 1349.5 ([M+H]⁺) |
| D-E3-1 | MS (ESI⁺) m/z: 1557.6 ([M+H]⁺) |
| D-E3-2 | MS (ESI⁺) m/z: 1557.6 ([M+H]⁺) |
| D-E3-3 | MS (ESI⁺) m/z: 1525.6 ([M+H]⁺) |
| D-E4-1 | MS (ESI⁺) m/z: 1419.4 ([M+H]⁺) |
| D-E4-2 | MS (ESI⁺) m/z: 1419.4 ([M+H]⁺) |
| D-E4-3 | MS (ESI⁺) m/z: 1386.5 ([M+H]⁺) |
| D-E5-1 | MS (ESI⁺) m/z: 1381.5, 242.3 ([M+H]⁺) |
| D-E5-2 | MS (ESI⁺) m/z: 1381.5,242.3 ([M+H]⁺) |
| D-E5-3 | MS (ESI⁺) m/z: 1349.5,242.3 ([M+H]⁺) |
| D-E6-1 | MS (ESI⁺) m/z: 1402.5 ([M+H]⁺) |
| D-E6-2 | MS (ESI⁺) m/z: 1402.5 ([M+H]⁺) |
| D-E6-3 | MS (ESI⁺) m/z: 1370.5 ([M+H]⁺) |
| D-E7-1 | MS (ESI⁺) m/z: 1415.4 ([M+H]⁺) |
| D-E7-2 | MS (ESI⁺) m/z: 1415.4 ([M+H]⁺) |
| D-E7-3 | MS (ESI⁺) m/z: 1383.4 ([M+H]⁺) |
| D-E8-1 | MS (ESI⁺) m/z: 1399.4 ([M+H]⁺) |
| D-E8-2 | MS (ESI⁺) m/z: 1399.4 ([M+H]⁺) |
| D-E8-3 | MS (ESI⁺) m/z: 1367.5 ([M+H]⁺) |
| D-E9-1 | MS (ESI⁺) m/z: 1381.5,354.4 ([M+H]⁺) |
| D-E9-2 | MS (ESI⁺) m/z: 1381.5, 354.4 ([M+H]⁺) |
| D-E9-3 | MS (ESI⁺) m/z: 1349.5, 354.4 ([M+H]⁺) |
| D-E10-1 | MS (ESI⁺) m/z: 1381.5, 102.1 ([M+H]⁺) |
| D-E10-2 | MS (ESI⁺) m/z: 1381.5, 102.1 ([M+H]⁺) |
| D-E10-3 | MS (ESI⁺) m/z: 1349.5, 102.1 ([M+H]⁺) |
| D-E11-1 | MS (ESI⁺) m/z: 1381.5, 186.2 ([M+H]⁺) |
| D-E11-2 | MS (ESI⁺) m/z: 1381.5, 186.2 ([M+H]⁺) |
| D-E11-3 | MS (ESI⁺) m/z: 1349.5, 186.2 ([M+H]⁺) |

### Example 2 (Production of Dye-Sensitized Solar Cell)

A dye-sensitized solar cell 20 (in a scale of 5 mm × 5 mm) shown in Fig. 2 was produced by a procedure shown below, using each of the metal complex dyes synthesized in Example 1 or each of the following comparative compounds (C1) to (C3), and the following performance was evaluated. The results are shown in Tables 2-1 and 2-2 (which are sometimes referred to Table 2).

### (Manufacture of Light-Receiving Electrode Precursor)

An electrically conductive support 41 having a fluorine-doped SnO₂ electrically-conductive film (transparent electrically-conductive film 43, film thickness of 500 nm) on a glass substrate (substrate 44, thickness of 4 mm) was manufactured. Further, the glass substrate having the SnO₂ electrically-conductive film formed thereon was immersed in a 40 mM aqueous titanium trichloride solution for 30 minutes, washed with ultrapure water and ethanol, and then calcined at 450°C to form a thin film layer of a titania coating film (metal oxide coating film, not shown in Fig. 2) on the SnO₂ electrically-conductive film.

A titania paste "18NR-T" (manufactured by DyeSol) was screen-printed on the titania coating film, followed by drying at 120°C. Then, the titania paste "18NR-T" was screen-printed again, followed by drying at 120°C for 1 hour. Thereafter, the dried titania paste was calcined at 500°C to form a semiconductor layer 45 (film thickness; 10 µm). Further, a titania paste "18NR-AO" (manufactured by DyeSol) was screen-printed on this semiconductor layer 45, and then dried at 120°C for 1 hour. Thereafter, the dried titania paste was calcined at 500°C to form a semiconductor layer 45. Then, this glass substrate was immersed in a 20 mM aqueous titanium trichloride solution, washed with ultrapure water and ethanol, and heated at 460°C for 30 minutes for each of the glass substrates. The glass substrate was left to be cooled to form a light-scattering layer 46 (film thickness: 5 µm) on the semiconductor layer 45. By this procedure, a photoconductor layer 42 (the area of the light-receiving surface; 5 mm × 5 mm, film thickness; 15 µm, a metal complex dye being carried) was formed on the SnO₂ electrically-conductive film.

As a result, a light-receiving electrode precursor not carrying a metal complex dye was manufactured.

### (Dye Adsorbing Method)

Next, each of the metal complex dyes (D-E1-1 to D-E11-3) synthesized in Example 1 was carried onto the photoconductor layer 42 not carrying a metal complex dye in the following manner.

First, for each of the metal complex dyes D-E1 to D-E11, a dye solution as a dye composition was prepared. That is, the metal complex dyes shown in Table 2 were mixed at the molar ratio shown in Table 2 in a mixed solvent of t-butanol and acetonitrile at 1:1 (volume ratio) such that the total concentration of the metal complex dyes became 2 × 10⁻⁴ mol/L. Further, chenodeoxycholic acid as a co-adsorbent was added in an amount of 10 moles per mole of the metal complex dye, thereby preparing each of dye solutions.

In the dye compositions shown in Table 2, the total molar amount (2 moles) of M¹ and M² contained in the metal complex dye, and the presence ratio of the metal cation to the non-metal cation is the same as follows.

The numbers of moles of the dye compositions with Sample Nos. 1 to 14 are each 0, and the numbers of moles of the dye compositions with Sample Nos. 15 to 43 are each 1. Further, the numbers of moles of the dye compositions with Sample Nos. 44, 45, and 46 are 0.05 moles, 0.025 moles, and 0.01 moles, respectively.

Next, the light-receiving electrode precursor was immersed in each of the dye solutions at 25°C for 5 hours, and then taken out from the dye solution and dried to manufacture each of light-receiving electrodes 40 having the respective metal complex dyes carried on the light-receiving electrode precursor.

### (Assembly of Dye-Sensitized Solar Cell)

A platinum electrode (thickness of a Pt thin film; 100 nm) having the same shape and size as those of the electrically conductive support 41 was manufactured as the counter electrode 48. Further, 0.001 M (mol/L) of iodine, 0.1 M of lithium iodide, 0.5 M of 4-t-butylpyridine, and 0.6 M of 1,2-dimethyl-3-propylimidazolium iodide were dissolved in acetonitrile to prepare a liquid electrolyte as an electrolytic solution. In addition, Spacer-S (trade name: "SURLYN") manufactured by DuPont, which has a shape matching to the size of the photoconductor layer 42, was prepared.

Each of the light-receiving electrodes 40 manufactured as above and the counter electrode 48 were arranged to face each other through the Spacer S, and thermally compressed, and then the liquid electrolyte was filled from the inlet for the electrolytic solution between the photoconductor layer 42 and the counter electrode 48, thereby forming a charge transfer layer 47. The outer periphery and the inlet for the electrolytic solution of the cell thus manufactured were sealed and cured using RESIN XNR-5516 manufactured by Nagase ChemteX Corporation, thereby producing each of dye-sensitized solar cells (Sample Nos. 1 to 46).

Comparative dye-sensitized solar cells (Sample Nos. c1 to c3) were produced in the same manner as for the production of the dye-sensitized solar cells except that each of the following comparative metal complex dyes (C1) to (C3) was used instead of the metal complex dye synthesized in Example 1 in the production of the dye-sensitized solar cell.

The metal complex dye (C1) is the compound "40" described in JP2008-021496A.

The metal complex dye (C2) is the compound "D-1-7a" described in JP20 13-072079A.

The metal complex dye (C3) is the compound "D-3" described in JP2001-291534A.

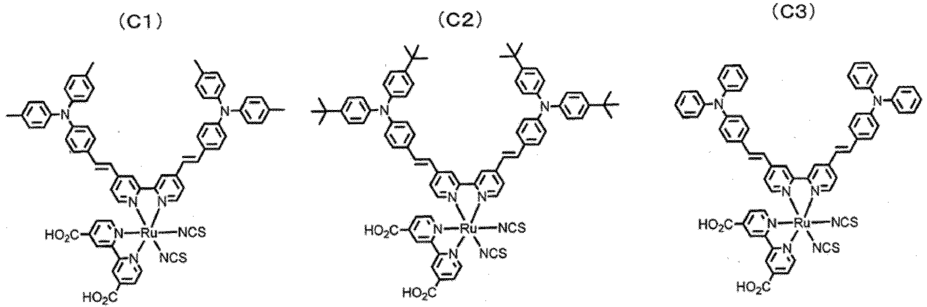

### <Adsorption Amount of Dye in Photoelectric Conversion Element>

In each of the produced dye-sensitized solar cells, the adsorption amount of the metal complex dye adsorbed onto the semiconductor fine particles was measured. Specifically, a photosensitive layer of each of the dye-sensitized solar cells was immersed in a solution of tetrabutylammoniumhydroxide in methanol to elute the metal complex dye. The elution solution was measured by HPLC under the above conditions to determine the adsorption amount of each of the metal complex dyes adsorbed on the semiconductor fine particles of each of the dye-sensitized solar cells. As a result, each of the dye-sensitized solar cells, the ratio the adsorption amount of each of the metal complex dyes was consistent with the content ratio (molar ratio) of each of the metal complex dyes in the dye composition used.

### <Evaluation of Photoelectric Conversion Efficiency: Evaluation Method [A] (Low-Illumination Solar Light)>

The cell characteristic test was carried out by using each of the produced dye-sensitized solar cells. The cell characteristic test was carried out by irradiating artificial solar light regulated to a predetermined luminance (1 mW/cm² (1,000 lux)) with ND filters (ND1 to ND80 manufactured by Shibuya Optical Co., Ltd.), using a Solar Simulator (WXS-85H, manufactured by WACOM). The regulated luminance was measured using a spectrophotometer USB4000 manufactured by Ocean Photonics, Inc. The current-voltage characteristics were measured using an I-V tester to determine a photoelectric conversion efficiency. The photoelectric conversion efficiency in this case is referred to as a conversion efficiency [A].

For each of the dye-sensitized solar cells (Sample Nos. 1 to 46 and c1 to c3) with the respective Sample Nos., the determined conversion efficiency [A] was evaluated in accordance with the following evaluation standard in comparison with that of the conversion efficiency [A_{c1}] of the comparative dye-sensitized solar cell (Sample No. c1).

In the present invention, with regard to the evaluation of the conversion efficiency [A], evaluations as S, A, and B are the acceptable levels in the present test, with S and A being preferable.

The conversion efficiency [A] was evaluated as follows, in comparison with that of the conversion efficiency [A_{c1}].
S: More than 1.3 times
A: More than 1.2 times and 1.3 times or less
B: More than 1.1 times and 1.2 times or less
C: 1.1 times or less

In Table 2, "Standard" means 1.0 time.

The conversion efficiency [A] of each of the dye-sensitized solar cells with Sample Nos. 1 to 46 indicates that each of the dye-sensitized solar cells sufficiently functioned as a dye-sensitized solar (photoelectrochemical) cell under low-illumination solar light. For example, the conversion efficiency [A] of the dye-sensitized solar cell with Sample No. 4 was 9%.

### <Evaluation of Photoelectric Conversion Efficiency: Evaluation Method [B] (Low-Illumination Environment: Indoor Light)>

The cell characteristic test was carried out by using each of the produced dye-sensitized solar cells. The cell characteristic test was carried out using White LED (Product No.: LDA8N-G-K/D/60 W) manufactured by Toshiba. Adjustment of luminance (300 µW/cm² (1,000 lux)) was carried out with ND filters (ND1 to ND80) commercially available from Shibuya Optical Co., Ltd. Measurement of the regulated luminance was confirmed using a spectrophotometer USB4000 manufactured by Ocean Photonics, Inc. The current-voltage characteristics were measured using an I-V tester to determine a photoelectric conversion efficiency. The photoelectric conversion efficiency in this case is referred to as a conversion efficiency [B].

For each of the dye-sensitized solar cells of the respective Sample Nos. (Sample Nos. 1 to 46 and c1 to c3), the determined conversion efficiency [B] was evaluated in accordance with the following evaluation standard in comparison with that of the conversion efficiency [B_{c1}] of the comparative dye-sensitized solar cell (Sample No. c1).

In the present invention, for evaluation of the conversion efficiency [B], evaluations as S, A, and B are the acceptable levels in the present test, with S and A being preferable.

The conversion efficiency [B] was evaluated as follows, in comparison with that of the conversion efficiency [B_{c1}].
S: More than 1.3 times
A: More than 1.2 times and 1.3 times or less
B: More than 1.1 times and 1.2 times or less
C: 1.1 time or less

In Table 2, "Standard" means 1.0 time.

The conversion efficiency [B] of each of the dye-sensitized solar cells with Sample Nos. 1 to 46 indicates that each of the dye-sensitized solar cells sufficiently functioned as a dye-sensitized photo electrochemical cell under low-illumination environment. For example, the conversion efficiency [A] of the dye-sensitized solar cell with Sample No. 4 was 11%.

The photoelectric conversion efficiency in a high-illumination solar light environment was evaluated by irradiating the dye-sensitized solar cells of the respective Sample Nos. with 1,000 W/m² (100,000 lux) of artificial solar light from a xenon lamp that passed through an AM1.5 filter. As a result, each of the dye-sensitized solar cells sufficiently functioned as a dye-sensitized photoelectrochemical cell. For example, the conversion efficiency of the dye-sensitized solar cell with Sample No. 4 was 8%.

### <Evaluation of Deviation of Conversion Efficiency: Evaluation Method [A]>

For each of the dye-sensitized solar cells (Sample Nos. 1 to 46 and c1 to c3) of the respective Sample Nos., three specimens were produced in the same manner as in the production of a dye-sensitized solar cell (immersion time of the light-receiving electrode precursor in the dye solution: 5 hours). With regard to the produced dye-sensitized solar cells, the conversion efficiency [B^{D1}] was determined in the same manner as in "Evaluation of Photoelectric Conversion Efficiency: Evaluation Method [B] (Low-Illumination Environment: Indoor Light)". In the dye-sensitized solar cells of the respective Sample Nos., a value (also referred to as a deviation [A]) obtained by subtracting the lowest conversion efficiency [B^{D1}_{MIN}] from the highest conversion efficiency [B^{D1}_{MAX}] out of the three dye-sensitized solar cells, and then dividing the resulting value by the highest conversion efficiency [B^{D1}_{MAX}] was calculated, and evaluated in accordance with the following evaluation standard.

In the present invention, for the evaluation in Evaluation of Deviation of Conversion Efficiency: Evaluation Method [A], evaluations as S, A⁺, and A⁻ are the acceptable levels in the present test, with S and A⁺ being preferable.

The deviation [A] was evaluated as follows.
S: 0.05 or less
A⁺: More than 0.05 and 0.07 or less
A⁻: More than 0.07 and 0.10 or less
B: More than 0.10

### <Evaluation of Deviation of Conversion Efficiency: Evaluation Method [B]>

In the same manner as in the production of the dye-sensitized solar cells except that the immersion time (dye adsorption time) of the light-receiving electrode precursor in the dye solution was changed to 20 hours in the production of the dye-sensitized solar cells, the respective metal complex dyes were carried to produce dye-sensitized solar cells (three specimens) of the respective Sample Nos.

With regard to the produced dye-sensitized solar cells, the conversion efficiency [B^{D2}] was determined in the same manner as in "Evaluation of Deviation of Conversion Efficiency: Evaluation Method [A]". In the dye-sensitized solar cells of the respective Sample Nos., a value (also referred to as a deviation [B]) obtained by subtracting the lowest conversion efficiency [B^{D2}_{MIN}] from the highest conversion efficiency [B^{D2}_{MAX}] out of the three dye-sensitized solar cells, and then dividing the resulting value by the highest conversion efficiency [B^{D2}_{MAX}] was calculated, and evaluated in accordance with the following evaluation standard.

In the present invention, for the evaluation in Evaluation of Deviation of Conversion Efficiency: Evaluation Method [B], evaluations as S, A⁺, and A⁻ are the acceptable levels in the present test, with S and A⁺ being preferable.

The deviation [B] was evaluated as follows.
S: 0.05 or less
A⁺: More than 0.05 and 0.07 or less
A⁻: More than 0.07 and 0.10 or less
B: More than 0.10

**[Table 2-1]**

| Table 2-1 | | | | | | |
|---|---|---|---|---|---|---|
| Sample No. | Metal complex dye (dye composition) and molar ratio thereof | Deviation [A] | Deviation [B] | Conversion efficiency [A] | Conversion efficiency [B] | Note |
| 1 | D-E1-1/D-E1-2=1/0.25 | A⁺ | A⁺ | A | A | The present invention |
| 2 | D-E1-1/D-E1-2=1/1 | A⁺ | A⁺ | A | A | The present invention |
| 3 | D-E2-1/D-E2-2=1/0.01 | A⁺ | A⁺ | A | S | The present invention |
| 4 | D-E2-1/D-E2-2=1/0.05 | A⁺ | A⁺ | A | S | The present invention |
| 5 | D-E2-1/D-E2-2=1/0.11 | A⁺ | A⁺ | A | S | The present invention |
| 6 | D-E2-1/D-E2-2=1/0.25 | S | S | S | S | The present invention |
| 7 | D-E2-1/D-E2-2=1/0.43 | S | S | S | S | The present invention |
| 8 | D-E2-1/D-E2-2=1/0.67 | S | S | A | S | The present invention |
| 9 | D-E2-1/D-E2-2=1/1 | S | S | A | A | The present invention |
| 10 | D-E2-1/D-E2-2=1/1.5 | A⁺ | A⁺ | A | A | The present invention |
| 11 | D-E2-1/D-E2-2/D-E2-3=1/0.36/0.07 | A⁺ | S | A | A | The present invention |
| 12 | D-E2-1/D-E2-3=1/0.05 | A⁻ | A⁻ | A | A | The present invention |
| 13 | D-E3-1/D-E3-2=1/0.25 | A⁺ | A⁺ | A | A | The present invention |
| 14 | D-E3-1/D-E3-2=1/1 | A⁻ | A⁻ | A | A | The present invention |
| 15 | D-E4-1/D-E4-2=1/0.03 | S | S | A | S | The present invention |
| 16 | D-E4-1/D-E4-2=1/0.25 | S | S | A | S | The present invention |
| 17 | D-E4-1/D-E4-2=1/0.43 | S | S | A | S | The present invention |
| 18 | D-E4-1/D-E4-2=1/1 | S | S | A | A | The present invention |
| 19 | D-E4-1/D-E4-2/D-E4-3=1/036/0.07 | A⁺ | S | A | S | The present invention |
| 20 | D-E4-1/D-E4-3=1/0.05 | A⁻ | A⁻ | A | A | The present invention |
| 21 | D-E5-1/D-E5-2=1/0.11 | S | S | A | S | The present invention |
| 22 | D-E5-1/D-E5-2=1/0.43 | S | S | A | S | The present invention |
| 23 | D-E5-1/D-E5-2=1/1 | A⁺ | S | A | A | The present invention |
| 24 | D-E5-1/D-E5-2/D-ES-3=1/0.36/0.07 | A⁺ | S | A | S | The present invention |
| 25 | D-E5-1/D-E5-3=1/0.05 | A⁻ | A⁻ | A | A | The present invention |

**[Table 2-2]**

| Table 2-2 | | | | | | |
|---|---|---|---|---|---|---|
| Sample No. | Metal complex dye (dye composition) and molar ratio thereof | Deviation [A] | Deviation [B] | Conversi on efficiency [A] | Conversi on efficiency [B] | Note |
| 26 | D-E6-1/D-E6-2=1/0.25 | S | S | A | S | The present invention |
| 27 | D-E6-1/D-E6-2=1/0.43 | S | S | A | S | The present invention |
| 28 | D-E6-1/D-E6-2=1/1 | A⁺ | S | A | A | The present invention |
| 29 | D-E6-1/D-E6-2/D-E6-3=1/036/0.07 | A⁻ | S | A | A | The present invention |
| 30 | D-E6-1/D-E6-3=1/0.05 | A⁻ | A | A | A | The present invention |
| 31 | D-E7-1/D-E7-2=1/0.11 | A⁻ | A⁻ | B | B | The present invention |
| 32 | D-E7-1/D-E7-2-1/0.43 | A⁺ | A⁺ | B | B | The present invention |
| 33 | D-E7-1/D-E7-2=1/1 | A⁻ | A⁻ | B | B | The present invention |
| 34 | D-E8-1/D-E8-2=1/0.11 | A⁻ | A⁻ | B | B | The present invention |
| 35 | D-E8-1/D-E8-2=1/0.43 | A⁺ | A⁺ | B | B | The present invention |
| 36 | D-E8-1/D-E8-2=1/1 | A⁻ | A⁻ | B | B | The present invention |
| 37 | D-E9-1/D-E9-2=1/0.08 | A⁺ | A⁺ | A | S | The present invention |
| 38 | D-E9-1/D-E9-2=1/0.40 | A⁺ | A⁺ | A | S | The present invention |
| 39 | D-E9-1/D-E9-2/D-E9-3=1/0.2/0.05 | A⁺ | S | A | S | The present invention |
| 40 | D-E10-1/D-E10-2=1/0.15 | A⁺ | A⁺ | A | A | The present invention |
| 41 | D-E10-1/D-E10-2/D-E10-3=1/036/0.07 | A⁺ | A⁺ | A | S | The present invention |
| 42 | D-E11-1/D-E11-2=1/0.1 | A⁺ | A⁺ | A | A | The present invention |
| 43 | D-E11-1/D-E11-2/D-E11-3=1/0.4/0.1 | A⁺ | A⁺ | A | S | The present invention |
| 44 | D-E2-1/D-E2-2/D-E6-1/D-E6-2 = 1/0.25/0.05/0.0125 | S | S | A | S | The present invention |
| 45 | D-E2-1/D-E2-2/D-E6-1/D-E6-2 = 1/0.25/0.025/0.00625 | S | S | S | S | The present invention |
| 46 | D-E2-1/D-E2-2/D-E6-1/D-E6-2 = 1/0.25/0.01/0.0025 | S | S | S | S | The present invention |
| c1 | (C1) | B | B | Standard | Standard | Comparative Example |
| c2 | (C2) | B | B | A | A | Comparative Example |
| c3 | (C3) | B | B | C | C | Comparative Example |

### From the results of Table 2, the following findings could be obtained.

All of the metal complex dyes (Sample Nos. 1 to 46) having the metal complex dye (1), and at least one metal complex dye selected from the group consisting of the metal complex dye (2) and the metal complex dye (3) had excellent results for the deviations [A] and [B], and a sufficient reduction in the deviation of the photoelectric conversion efficiency. Further, these photoelectric conversion elements and dye-sensitized solar cells had a sufficiently high photoelectric conversion efficiency in a low-illumination environment, and could satisfy both of the photoelectric conversion efficiency and a reduction in the deviation thereof at a high level, thus exhibiting excellent cell performance.

To the contrary, the comparative photoelectric conversion elements and dye-sensitized solar cells (Sample Nos. c1 to c3) have each single metal complex dye of the metal complex dyes (C1) to (C3). These photoelectric conversion elements and dye-sensitized solar cells were not sufficient in terms of a reduction in the deviation of the photoelectric conversion efficiency.
1, 41: electrically conductive support
2, 42: photoconductor layer (oxide semiconductor electrode)
21: dye
22: semiconductor fine particle
3, 47: charge transfer layer
4, 48: counter electrodes
5, 40: light-receiving electrode
6: circuit
10: photoelectric conversion element
100: system in which photoelectric conversion element is applied to cell uses
M: operating means (for example, electric motor)
20: dye-sensitized solar cell
43: transparent electrically-conductive film
44: substrate
45: semiconductor layer
46: light-scattering layer
S: spacer

## Claims

1. A photoelectric conversion element comprising:
an electrically conductive support;
a photoconductor layer including an electrolyte;
a charge transfer layer including an electrolyte; and
a counter electrode,
wherein the photoconductor layer has semiconductor fine particles carrying a metal complex dye represented by Formula (1), and at least one metal complex dye selected from the group consisting of a metal complex dye represented by Formula (2) and a metal complex dye represented by Formula (3), 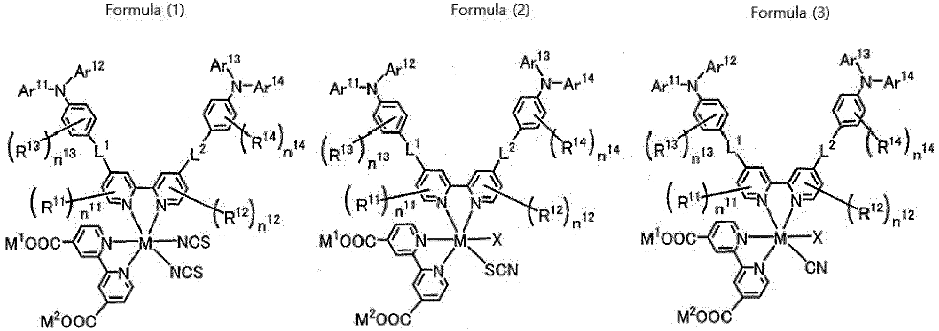
in the formula, M represents a metal ion,
Ar¹¹ to Ar¹⁴ each independently represent an aryl group or a heteroaryl group, each having a substituent selected from a substituent group T,
<Substituent group T>:
an alkyl group, an alkenyl group, an alkynyl group, a cycloalkyl group, an cycloalkenyl group, an aryl group, a heterocyclic group, an alkoxy group, an alkenyloxy group, an alkynyloxy group, a cycloalkyloxy group, an aryloxy group, a heterocyclic oxy group, an alkoxycarbonyl group, a cycloalkoxycarbonyl group, an aryloxycarbonyl group, an amino group, a sulfamoyl group, an acyl group, an acyloxy group, a carbamoyl group, an acylamino group, a sulfonamido group, an alkylthio group, a cycloalkylthio group, an arylthio group, an alkyl-, cycloalkyl-, or aryl-sulfonyl group, a silyl group, a silyloxy group, a hydroxyl group, a cyano group, a nitro group, and a halogen atom,
L¹ and L² each independently represent an ethenylene group or an ethynylene group,
R¹¹ to R¹⁴ each independently represent an alkyl group, an alkoxy group, an aryl group, an alkylthio group, a heteroaryl group, an amino group, or a halogen atom, n¹¹ and n¹² each independently represent an integer of 0 to 3, and n¹³ and n¹⁴ each independently represent an integer of 0 to 4,
X's each independently represent an isothiocyanate group or a thiocyanate group, and
M¹ and M² each independently represent any one of a proton, a metal cation, and a non-metal cation.

2. The photoelectric conversion element according to claim 1,
wherein at least one of the metal complex dyes includes the metal complex dye represented by Formula (2).

3. The photoelectric conversion element according to claim 1 or 2,
wherein Ar¹¹ to Ar¹⁴ are each independently represented by any one of Formulae (2-1) to (2-5), 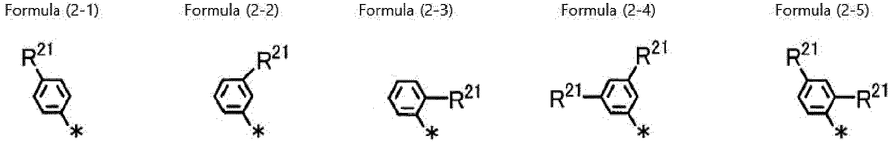 in the formula, R²¹ represents a hydrogen atom, an alkyl group, an aryl group, a heteroaryl group, an alkoxy group, or a halogen atom, and ^{∗} represents a bonding moiety to a nitrogen atom.

4. The photoelectric conversion element according to any one of claims 1 to 3,
wherein the semiconductor fine particles carries a metal complex dye including at least the metal complex dye represented by Formula (1) and the metal complex dye represented by Formula (2), and the content ratio of the metal complex dye represented by Formula (1) to the metal complex dye represented by Formula (2) in this case is 1.0/0.01 to 2 in terms of the molar ratio of the metal complex dye represented by Formula (1)/the metal complex dye represented by Formula (2).

5. The photoelectric conversion element according to any one of claims 1 to 4,
wherein a metal oxide coating film is included on the surface of at least one of the electrically conductive support or the semiconductor fine particles.

6. The photoelectric conversion element according to any one of claims 1 to 5, which is a dye-sensitized solar cell.

7. A dye composition comprising a metal complex dye represented by Formula (1), and at least one metal complex dye selected from the group consisting of a metal complex dye represented by Formula (2) and a metal complex dye represented by Formula (3), 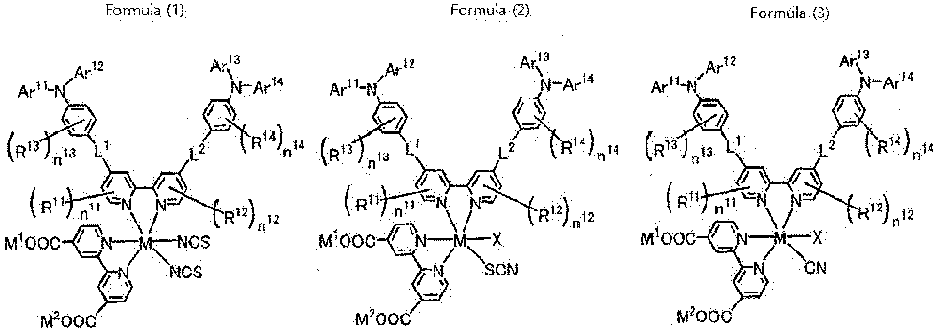 in the formula, M represents a metal ion,
Ar¹¹ to Ar¹⁴ each independently represent an aryl group or a heteroaryl group, each having a substituent selected form a substituent group T,
<Substituent group T>:
an alkyl group, an alkenyl group, an alkynyl group, a cycloalkyl group, an cycloalkenyl group, an aryl group, a heterocyclic group, an alkoxy group, an alkenyloxy group, an alkynyloxy group, a cycloalkyloxy group, an aryloxy group, a heterocyclic oxy group, an alkoxycarbonyl group, a cycloalkoxycarbonyl group, an aryloxycarbonyl group, an amino group, a sulfamoyl group, an acyl group, an acyloxy group, a carbamoyl group, an acylamino group, a sulfonamido group, an alkylthio group, a cycloalkylthio group, an arylthio group, an alkyl-, cycloalkyl-, or aryl-sulfonyl group, a silyl group, a silyloxy group, a hydroxyl group, a cyano group, a nitro group, and a halogen atom,
L¹ and L² each independently represent an ethenylene group or an ethynylene group,
R¹¹ to R¹⁴ each independently represent an alkyl group, an alkoxy group, an aryl group, an alkylthio group, a heteroaryl group, an amino group, or a halogen atom, n¹¹ and n¹² each independently represent an integer of 0 to 3, and n¹³ and n¹⁴ each independently represent an integer of 0 to 4, and
X's each independently represent an isothiocyanate group or a thiocyanate group.
M¹ and M² each independently represent any one of a proton, a metal cation, and a non-metal cation.

8. The dye composition according to claim 7,
wherein 0.000001 to 1.5 moles in total of the metal cation and the non-metal cation in the total molar amount of M¹ and M² contained in the metal complex dye are contained.

9. The dye composition according to claim 7 or 8, comprising at least:
the metal complex dye represented by Formula (1); and
the metal complex dye represented by Formula (2),
wherein the content ratio of the metal complex dye represented by Formula (1) to the metal complex dye represented by Formula (2) in this case is 1.0/0.01 to 2 in terms of the molar ratio of the metal complex dye represented by Formula (1)/the metal complex dye represented by Formula (2).

10. The dye composition according to any one of claims 7 to 9, comprising a solvent.

11. An oxide semiconductor electrode comprising the dye composition according to any one of claims 7 to 10.

## Patentansprüche

1. Fotoelektrisches Umwandlungselement, umfassend:
einen elektrisch leitenden Träger;
eine Fotoleiterschicht, enthaltend einen Elektrolyten;
eine Ladungsübertragungsschicht, enthaltend einen Elektrolyten; und
eine Gegenelektrode,
wobei die Fotoleiterschicht Halbleiter-Feinpartikel aufweist, die einen Metallkomplexfarbstoff, dargestellt durch Formel (1), und mindestens einen Metallkomplexfarbstoff, ausgewählt aus der Gruppe, bestehend aus einem Metallkomplexfarbstoff, dargestellt durch Formel (2), und einem Metallkomplexfarbstoff, dargestellt durch Formel (3), tragen, 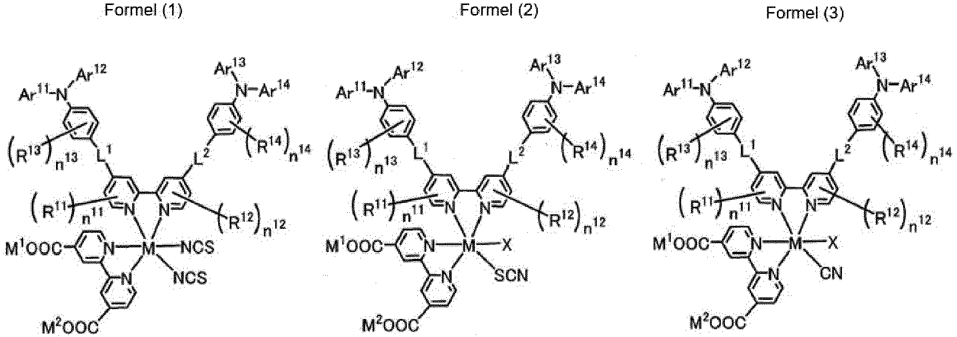
wobei in der Formel M für ein Metallion steht,
Ar¹¹ bis Ar¹⁴ jeweils unabhängig voneinander für eine Arylgruppe oder eine Heteroarylgruppe stehen, die jeweils einen Substituenten, ausgewählt aus einer Substituentengruppe T, aufweisen,
<Substituentengruppe T>:
eine Alkylgruppe, eine Alkenylgruppe, eine Alkinylgruppe, eine Cycloalkylgruppe, eine Cycloalkenylgruppe, eine Arylgruppe, eine heterocyclische Gruppe, eine Alkoxygruppe, eine Alkenyloxygruppe, eine Alkinyloxygruppe, eine Cycloalkyloxygruppe, eine Aryloxygruppe, eine heterocyclische Oxygruppe, eine Alkoxycarbonylgruppe, eine Cycloalkoxycarbonylgruppe, eine Aryloxycarbonylgruppe, eine Aminogruppe, eine Sulfamoylgruppe, eine Acylgruppe, eine Acyloxygruppe, eine Carbamoylgruppe, eine Acylaminogruppe, eine Sulfonamidogruppe, eine Alkylthiogruppe, eine Cycloalkylthiogruppe, eine Arylthiogruppe, eine Alkyl-, Cycloalkyl- oder Arylsulfonylgruppe, eine Silylgruppe, eine Silyloxygruppe, eine Hydroxylgruppe, eine Cyanogruppe, eine Nitrogruppe und ein Halogenatom,
L¹ und L² jeweils unabhängig voneinander für eine Ethenylengruppe oder eine Ethinylengruppe stehen,
R¹¹ bis R¹⁴ jeweils unabhängig voneinander für eine Alkylgruppe, eine Alkoxygruppe, eine Arylgruppe, eine Alkylthiogruppe, eine Heteroarylgruppe, eine Aminogruppe oder ein Halogenatom stehen, n¹¹ und n¹² jeweils unabhängig voneinander für eine ganze Zahl von 0 bis 3 stehen, und n¹³ und n¹⁴ jeweils unabhängig voneinander für eine ganze Zahl von 0 bis 4 stehen,
die X jeweils unabhängig voneinander für eine Isothiocyanatgruppe oder eine Thiocyanatgruppe stehen, und
M¹ und M² jeweils unabhängig voneinander für ein Proton, ein Metallkation oder ein Nichtmetallkation stehen.

2. Fotoelektrisches Umwandlungselement gemäß Anspruch 1,
wobei mindestens einer der Metallkomplexfarbstoffe den durch Formel (2) dargestellten Metallkomplexfarbstoff einschließt.

3. Fotoelektrisches Umwandlungselement gemäß Anspruch 1 oder 2,
wobei Ar¹¹ bis Ar¹⁴ jeweils unabhängig voneinander durch eine der Formeln (2-1) bis (2-5) dargestellt werden, 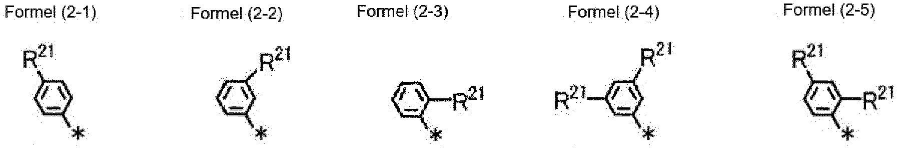 wobei in der Formel R²¹ für ein Wasserstoffatom, eine Alkylgruppe, eine Arylgruppe, eine Heteroarylgruppe, eine Alkoxygruppe oder ein Halogenatom steht, und * für eine Bindungsgruppe an einem Stickstoffatom steht.

4. Fotoelektrisches Umwandlungselement gemäß einem der Ansprüche 1 bis 3,
wobei die Halbleiter-Feinpartikel einen Metallkomplexfarbstoff tragen, der mindestens den durch Formel (1) dargestellten Metallkomplexfarbstoff und den durch Formel (2) dargestellten Metallkomplexfarbstoff einschließt, und das Gehaltsverhältnis von dem durch Formel (1) dargestellten Metallkomplexfarbstoff zu dem durch Formel (2) dargestellten Metallkomplexfarbstoff in Form des Molverhältnisses von dem durch Formel (1) dargestellten Metallkomplexfarbstoff/durch Formel (2) dargestellten Metallkomplexfarbstoff in diesem Fall 1,0/0,01 bis 2 beträgt.

5. Fotoelektrisches Umwandlungselement gemäß einem der Ansprüche 1 bis 4,
wobei ein Metalloxidbeschichtungsfilm auf der Oberflächen von mindestens einem von dem elektrisch leitenden Träger und den Halbleiter-Feinpartikeln vorhanden ist.

6. Fotoelektrisches Umwandlungselement gemäß einem der Ansprüche 1 bis 5, das eine Farbstoffsolarzelle ist.

7. Farbstoffzusammensetzung, umfassend einen Metallkomplexfarbstoff, dargestellt durch Formel (1), und mindestens einen Metallkomplexfarbstoff, ausgewählt aus der Gruppe, bestehend aus einem Metallkomplexfarbstoff, dargestellt durch Formel (2), und einem Metallkomplexfarbstoff, dargestellt durch Formel (3), 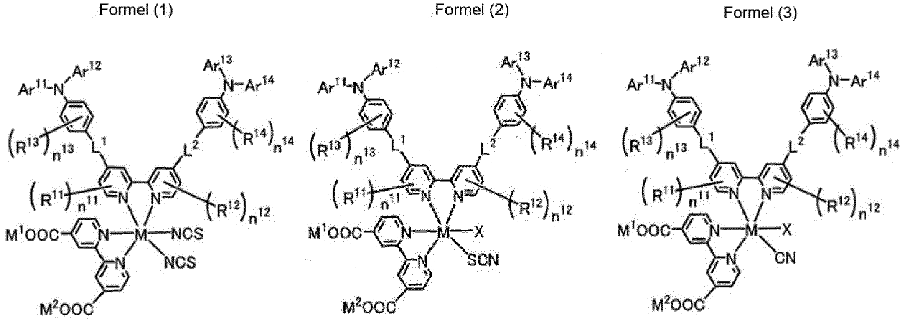 wobei in der Formel M für ein Metallion steht,
Ar¹¹ bis Ar¹⁴ jeweils unabhängig voneinander für eine Arylgruppe oder eine Heteroarylgruppe stehen, die jeweils einen Substituenten, ausgewählt aus einer Substituentengruppe T, aufweisen,
<Substituentengruppe T>:
eine Alkylgruppe, eine Alkenylgruppe, eine Alkinylgruppe, eine Cycloalkylgruppe, eine Cycloalkenylgruppe, eine Arylgruppe, eine heterocyclische Gruppe, eine Alkoxygruppe, eine Alkenyloxygruppe, eine Alkinyloxygruppe, eine Cycloalkyloxygruppe, eine Aryloxygruppe, eine heterocyclische Oxygruppe, eine Alkoxycarbonylgruppe, eine Cycloalkoxycarbonylgruppe, eine Aryloxycarbonylgruppe, eine Aminogruppe, eine Sulfamoylgruppe, eine Acylgruppe, eine Acyloxygruppe, eine Carbamoylgruppe, eine Acylaminogruppe, eine Sulfonamidogruppe, eine Alkylthiogruppe, eine Cycloalkylthiogruppe, eine Arylthiogruppe, eine Alkyl-, Cycloalkyl- oder Arylsulfonylgruppe, eine Silylgruppe, eine Silyloxygruppe, eine Hydroxylgruppe, eine Cyanogruppe, eine Nitrogruppe und ein Halogenatom,
L¹ und L² jeweils unabhängig voneinander für eine Ethenylengruppe oder eine Ethinylengruppe stehen,
R¹¹ bis R¹⁴ jeweils unabhängig voneinander für eine Alkylgruppe, eine Alkoxygruppe, eine Arylgruppe, eine Alkylthiogruppe, eine Heteroarylgruppe, eine Aminogruppe oder ein Halogenatom stehen, n¹¹ und n¹² jeweils unabhängig voneinander für eine ganze Zahl von 0 bis 3 stehen, und n¹³ und n¹⁴ jeweils unabhängig voneinander für eine ganze Zahl von 0 bis 4 stehen,
die X jeweils unabhängig voneinander für eine Isothiocyanatgruppe oder eine Thiocyanatgruppe stehen, und
M¹ und M² jeweils unabhängig voneinander für ein Proton, ein Metallkation oder ein Nicht-Metallkation stehen.

8. Farbstoffzusammensetzung gemäß Anspruch 7,
worin 0,000001 bis 1,5 Mol insgesamt des Metallkations und des Nichtmetallkations in der gesamten Molmenge von M¹ und M², die in dem Metallkomplexfarbstoff enthalten ist, enthalten sind.

9. Farbstoffzusammensetzung gemäß Anspruch 7 oder 8, mindestens umfassend:
den durch Formel (1) dargestellten Metallkomplexfarbstoff; und
den durch Formel (2) dargestellten Metallkomplexfarbstoff,
wobei das Gehaltsverhältnis von dem durch Formel (1) dargestellten Metallkomplexfarbstoff zu dem durch Formel (2) dargestellten Metallkomplexfarbstoff in Form des Molverhältnisses von dem durch Formel (1) dargestellten Metallkomplexfarbstoff/durch Formel (2) dargestellten Metallkomplexfarbstoff in diesem Fall 1,0/0,01 bis 2 beträgt.

10. Farbstoffzusammensetzung gemäß einem der Ansprüche 7 bis 9, umfassend ein Lösungsmittel.

11. Oxidhalbleiterelektrode, umfassend die Farbstoffzusammensetzung gemäß einem der Ansprüche 7 bis 10.

## Revendications

1. Élément de conversion photoélectrique comprenant :
un support électriquement conducteur ;
une couche photoconductrice incluant un électrolyte ;
une couche de transfert de charges incluant un électrolyte ; et
une contre-électrode,
dans lequel la couche photoconductrice présente de fines particules semi-conductrices portant un colorant de complexe métallique représenté par la Formule (1), et au moins un colorant de complexe métallique choisi dans le groupe consistant en un colorant de complexe métallique représenté par la Formule (2) et un colorant de complexe métallique représenté par la Formule (3), 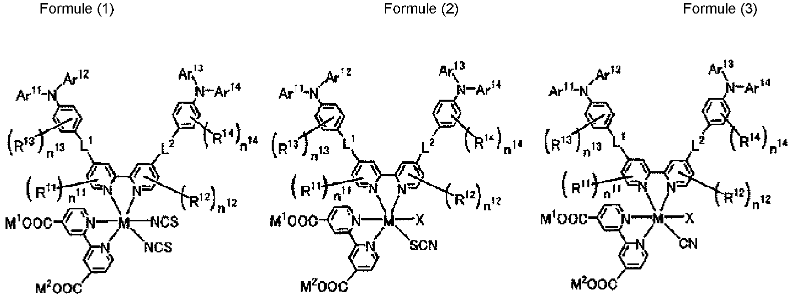
dans les formules, M représente un ion métallique,
Ar¹¹ à Ar¹⁴ représentent chacun indépendamment un groupe aryle ou un groupe hétéroaryle, chacun présentant un substituant choisi parmi un groupe de substituants T,
<Groupe de substituants T> :
un groupe alkyle, un groupe alcényle, un groupe alcynyle, un groupe cycloalkyle, un groupe cycloalcényle, un groupe aryle, un groupe hétérocyclique, un groupe alcoxy, un groupe alcényloxy, un groupe alcynyloxy, un groupe cycloalkyloxy, un groupe aryloxy, un groupe oxy hétérocyclique, un groupe alcoxycarbonyle, un groupe cycloalcoxycarbonyle, un groupe aryloxycarbonyle, un groupe amino, un groupe sulfamoyle, un groupe acyle, un groupe acyloxy, un groupe carbamoyle, un groupe acylamino, un groupe sulfonamido, un groupe alkylthio, un groupe cycloalkylthio, un groupe arylthio, un groupe alkyl-, cycloalkyl-, ou aryl-sulfonyle, un groupe silyle, un groupe silyloxy, un groupe hydroxyle, un groupe cyano, un groupe nitro, et un atome d'halogène,
L¹ et L² représentent chacun indépendamment un groupe éthénylène ou un groupe éthynylène,
R¹¹ à R¹⁴ représentent chacun indépendamment un groupe alkyle, un groupe alcoxy, un groupe aryle, un groupe alkylthio, un groupe hétéroaryle, un groupe amino, ou un atome d'halogène, n¹¹ et n¹² représentent chacun indépendamment un nombre entier de 0 à 3, et n¹³ et n¹⁴ représentent chacun indépendamment un nombre entier de 0 à 4,
les X représentent chacun indépendamment un groupe isothiocyanate ou un groupe thiocyanate, et
M¹ et M² représentent chacun indépendamment l'un quelconque d'un proton, d'un cation métallique, et d'un cation non-métallique.

2. Élément de conversion photoélectrique selon la revendication 1,
dans lequel au moins l'un des colorants de complexe métallique inclut le colorant de complexe métallique représenté par la Formule (2).

3. Élément de conversion photoélectrique selon la revendication 1ou 2,
dans lequel Ar¹¹ à Ar¹⁴ sont chacun indépendamment représentés par l'une quelconque des Formules (2-1) à (2-5), 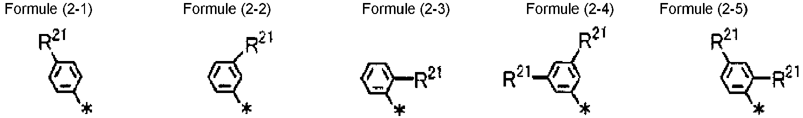 dans les formules, R²¹ représente un atome d'hydrogène, un groupe alkyle, un groupe aryle, un groupe hétéroaryle, un groupe alcoxy, ou un atome d'halogène, et ^{∗} représente un fragment de liaison à un atome d'azote.

4. Élément de conversion photoélectrique selon l'une quelconque des revendications 1 à 3,
dans lequel les fines particules semi-conductrices portent un colorant de complexe métallique incluant au moins le colorant de complexe métallique représenté par la Formule (1) et le colorant de complexe métallique représenté par la Formule (2), et le rapport de teneur entre le colorant de complexe métallique représenté par la Formule (1) et le colorant de complexe métallique représenté par la Formule (2) dans ce cas est de 1,0/0,01 à 2 en termes du rapport molaire du colorant de complexe métallique représenté par la Formule (1)/le colorant de complexe métallique représenté par la Formule (2).

5. Élément de conversion photoélectrique selon l'une quelconque des revendications 1 à 4,
dans lequel un film de revêtement d'oxyde métallique est inclus sur la surface d'au moins un parmi le support électriquement conducteur ou les fines particules semi-conductrices.

6. Élément de conversion photoélectrique selon l'une quelconque des revendications 1 à 5, qui est une cellule solaire sensibilisée par colorant.

7. Composition de colorant comprenant un colorant de complexe métallique représenté par la Formule (1), et au moins un colorant de complexe métallique choisi dans le groupe consistant en un colorant de complexe métallique représenté par la Formule (2) et un colorant de complexe métallique représenté par la Formule (3), 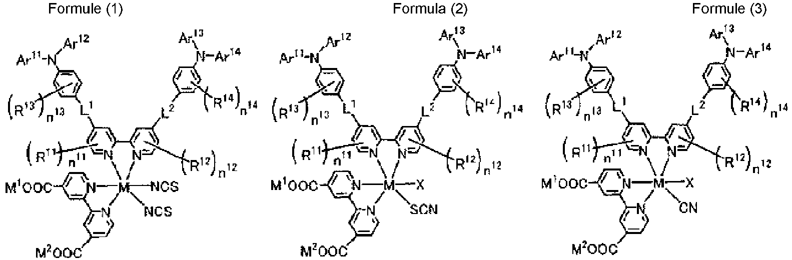
dans les formules, M représente un ion métallique,
Ar¹¹ à Ar¹⁴ représentent chacun indépendamment un groupe aryle ou un groupe hétéroaryle, chacun présentant un substituant choisi parmi un groupe de substituants T,
<Groupe de substituants T> :
un groupe alkyle, un groupe alcényle, un groupe alcynyle, un groupe cycloalkyle, un groupe cycloalcényle, un groupe aryle, un groupe hétérocyclique, un groupe alcoxy, un groupe alcényloxy, un groupe alcynyloxy, un groupe cycloalkyloxy, un groupe aryloxy, un groupe oxy hétérocyclique, un groupe alcoxycarbonyle, un groupe cycloalcoxycarbonyle, un groupe aryloxycarbonyle, un groupe amino, un groupe sulfamoyle, un groupe acyle, un groupe acyloxy, un groupe carbamoyle, un groupe acylamino, un groupe sulfonamido, un groupe alkylthio, un groupe cycloalkylthio, un groupe arylthio, un groupe alkyl-, cycloalkyl-, ou aryl-sulfonyle, un groupe silyle, un groupe silyloxy, un groupe hydroxyle, un groupe cyano, un groupe nitro, et un atome d'halogène,
L¹ et L² représentent chacun indépendamment un groupe éthénylène ou un groupe éthynylène,
R¹¹ à R¹⁴ représentent chacun indépendamment un groupe alkyle, un groupe alcoxy, un groupe aryle, un groupe alkylthio, un groupe hétéroaryle, un groupe amino, ou un atome d'halogène, n¹¹ et n¹² représentent chacun indépendamment un nombre entier de 0 à 3, et n¹³ et n¹⁴ représentent chacun indépendamment un nombre entier de 0 à 4, et
les X représentent chacun indépendamment un groupe isothiocyanate ou un groupe thiocyanate,
M¹ et M² représentent chacun indépendamment l'un quelconque d'un proton, d'un cation métallique, et d'un cation non-métallique.

8. Composition de colorant selon la revendication 7,
dans laquelle 0,000001 à 1,5 mole au total du cation métallique et du cation non-métallique est contenu dans la quantité molaire totale de M¹ et M² contenus dans le colorant de complexe métallique.

9. Composition de colorant selon la revendication 7 ou 8, comprenant au moins :
le colorant de complexe métallique représenté par la Formule (1) ; et
le colorant de complexe métallique représenté par la Formule (2),
dans laquelle le rapport de teneur entre le colorant de complexe métallique représenté par la Formule (1) et le colorant de complexe métallique représenté par la Formule (2) dans ce cas est de 1,0/0,01 à 2 en termes du rapport molaire du colorant de complexe métallique représenté par la Formule (1)/le colorant de complexe métallique représenté par la Formule (2).

10. Composition de colorant selon l'une quelconque des revendications 7 à 9, comprenant un solvant.

11. Électrode d'oxyde-semi-conducteur comprenant la composition de colorant selon l'une quelconque des revendications 7 à 10.
